(19) Europäisches Patentamt
European Patent Office
Office européen des brevets

(11) **EP 2 919 557 A1**

(12) **EUROPEAN PATENT APPLICATION**
published in accordance with Art. 153(4) EPC


(43) Date of publication:
**16.09.2015 Bulletin 2015/38**

(21) Application number: **13853206.4**

(22) Date of filing: **31.10.2013**

(51) Int Cl.:
***H05B 33/04*** *(2006.01)* ***B32B 9/00*** *(2006.01)*
***C23C 16/42*** *(2006.01)* ***C23C 16/50*** *(2006.01)*
***H01L 51/50*** *(2006.01)* ***H05B 33/02*** *(2006.01)*
***H05B 33/10*** *(2006.01)*

(86) International application number:
**PCT/JP2013/079484**

(87) International publication number:
**WO 2014/073438 (15.05.2014 Gazette 2014/20)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **09.11.2012 JP 2012247375**



(71) Applicant: **Konica Minolta, Inc.**
**Tokyo 100-7015 (JP)**

(72) Inventor: **SUZUKI, Issei**
**Tokyo 100-7015 (JP)**

(74) Representative: **Gille Hrabal**
**Brucknerstrasse 20**
**40593 Düsseldorf (DE)**


(54) **ELECTRONIC DEVICE AND GAS BARRIER FILM FABRICATION METHOD**


(57) An electronic device comprising a gas barrier film comprising, in sequence:
a resin substrate;
a gas barrier layer; and
an inorganic polymer layer,
wherein,
the gas barrier layer includes carbon atoms, silicon atoms, and oxygen atoms, the gas barrier layer having a composition of the carbon atoms, the silicon atoms, and the oxygen atoms continuously changing across the thickness of the gas barrier layer. The gas barrier layer satisfy specific Requirements, mentioned in the specification.


**FIG.5**

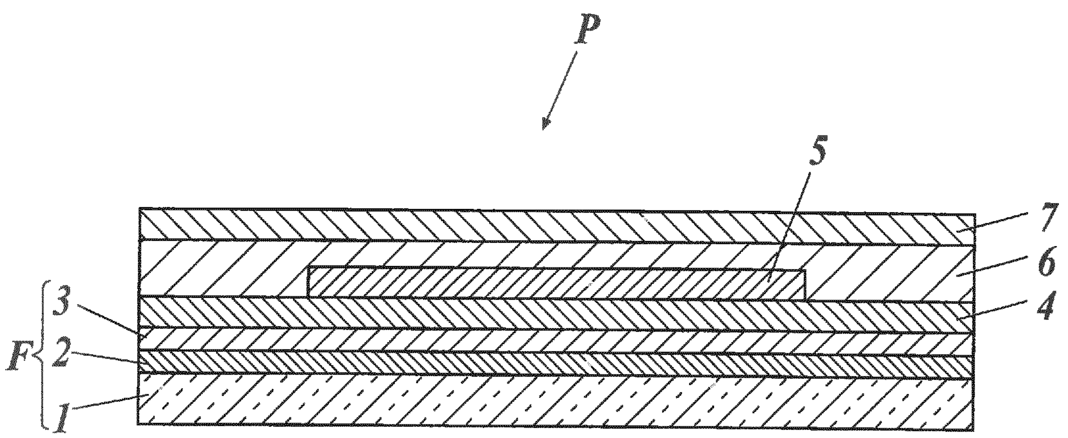


EP 2 919 557 A1

## Description

### Technical Field

The present invention relates to an electronic device including a gas barrier film and a method of manufacturing the gas barrier film.

### Background Art

A conventional gas barrier film that is a laminate of a plastic (film) substrate and several layers including metal oxide films composed of, for example, aluminum oxide, magnesium oxide, and silicon oxide are widely used for wrapping food, industrial, and pharmaceutical products which should be blocked from gases, such as moisture vapor and oxygen, in order to prevent alteration of the products.

Many studies have been conducted on development in use of gas barrier films in the form of flexible electronic devices, for example, flexible solar cell devices, flexible organic electroluminescent (EL) devices, and flexible liquid crystal displays, in addition to wrapping materials. Unfortunately, there are no gas barrier films that give sufficient performance to serve as these flexible electronic devices which should have significantly high gas-barrier properties at the glass substrate level.

The conventional gas barrier films are formed through a known process, for example, chemical deposition which involves oxidizing an organosilicon compound, such as tetraethoxysilane (hereinafter referred to as TEOS), in oxygen plasma to deposit the compounds on a substrate under reduced pressure (e.g., plasma-enhanced chemical vapor deposition (CVD)), or vapor-phase deposition which involves vaporizing metal silicon with a semiconductor laser and physically depositing the metal silicon on a substrate in the presence of oxygen (e.g., vacuum deposition and sputtering).

Patent Literature 1 discloses a method of manufacturing a gas barrier film having a moisture vapor permeation rate of $1\times10^{-4}$ g/m$^2$·day through a roll-to-roll process with a plasma-enhanced CVD apparatus. In Patent Literature 1, the gas barrier film, which is manufactured through the plasma-enhanced CVD, has many carbon atoms at the periphery of a substrate and thus exhibits high adhesion to the substrate and high flexibility.

Some electronic devices including gas barrier films having such elemental distribution profiles are disposed out of doors or on mobile objects, such as an automobile, during the day. For example, an electronic device on a mobile object, such as an automobile, is exposed to a high-temperature environment during long periods of traveling in summer. It is found that the above-described gas barrier film of the electronic device loses its flatness when being exposed to such a high-temperature environment.

### Prior Art Document

#### Patent Literature

Patent Literature 1: WO2012/046767

### Summary of Invention

#### Problems to be Solved by the Invention

An object of the present invention, which has been accomplished in view of the problems described above, is to provide an electronic device including a gas barrier film exhibiting high gas-barrier properties and durability (flatness and dark-spot resistance), and a method of manufacturing such a gas barrier film.

#### Means for Solving the Problem

To address the problems described above, the inventor of the present invention examined these problems and achieved the present invention: an electronic device including a gas barrier film including, in sequence, a resin substrate, a gas barrier layer, and an inorganic polymer layer, the gas barrier layer containing carbon atoms, silicon atoms, and oxygen atoms, the gas barrier layer having predetermined elemental distribution profiles with the composition continuously changing across the thickness, the inorganic polymer layer being formed by applying a polysilazane solution to form a coating layer; drying the coating layer; and contracting the dried coating layer into a contraction rate in a range of 10 to 30% in the thickness direction. The gas barrier film having these characteristics can exhibit high gas barrier properties and high durability required for the use in an electronic device, and an electronic device including such a gas

barrier film can exhibit high durability (flatness (curling characteristics) and dark-spot resistance).

Specifically, the advantageous effects of the present invention can be achieved by the following aspects:

1. An electronic device comprising a gas barrier film including, in sequence:

a resin substrate;
a gas barrier layer; and
an inorganic polymer layer,
wherein,
the gas barrier layer includes carbon atoms, silicon atoms, and oxygen atoms, the gas barrier layer having a composition of the carbon atoms, the silicon atoms, and the oxygen atoms continuously changing across the thickness of the gas barrier layer, the gas barrier layer satisfying Requirements (1) and (2),
the inorganic polymer layer is formed by performing contraction on a layer comprising polysilazane so that a contraction rate is in a range of 10 to 30%,

Requirement (1): in curves showing elemental distribution profiles based on elemental distribution measurement across a depth direction of the gas barrier layer observed through X-ray photoelectron spectroscopy, a carbon distribution curve, indicating correlation between a distance from one surface of the gas barrier layer in a thickness direction of the gas barrier layer and a percentage of the carbon atoms (referred to as "carbon atom percentage (at%)") to total content (100 at%) of silicon, oxygen, and carbon atoms, shows extrema; and a difference between a highest extremum (local maximum) of the carbon atom percentage and a lowest extremum (local minimum) of the carbon atom percentage is 5 at% or greater;
Requirement (2): in an area of 90% or greater of an entire thickness of the gas barrier layer, the respective average percentage of the silicon, oxygen, and carbon atoms to the total content of the silicon, oxygen, and carbon atoms (100 at%) have a correlation defined by the following Inequality (A) or (B):

Inequality (A): (average carbon atom percentage) < (average silicon atom percentage) < (average oxygen atom percentage);
Inequality (B): (average oxygen atom percentage) < (average silicon atom percentage) < (average carbon atom percentage).

2. The electronic device according to aspect 1, wherein the average percentage of the atom of each element have the correlation defined by Inequality (A).
3. The electronic device according to aspect 1 or 2, wherein the inorganic polymer layer has a contraction rate in a range of 15 to 20%.
4. The electronic device according to any of aspects 1 to 3, wherein the resin substrate of the gas barrier film has a thickness in a range of 15 to 150 μm.
5. A method of manufacturing a gas barrier film to be used in an electronic device, the gas barrier film comprising, in sequence, a resin substrate, at least one gas barrier layer deposited on at least one surface of the resin substrate, and at least one inorganic polymer layer deposited on the at least one gas barrier layer, the method including:

forming a gas barrier layer comprising carbon atoms, silicon atoms, and oxygen atoms, the gas barrier layer having a composition changing across a thickness direction, the gas barrier layer satisfying Requirements (1) and (2);
applying a polysilazane solution to form a coating layer onto the gas barrier layer;
drying the coating layer; and
contracting the dried coating layer into a contraction rate in a range of 10 to 30% to form an inorganic polymer layer:

Requirement (1): in curves showing elemental distribution profiles based on elemental distribution measurement across a depth direction of the gas barrier layer observed through X-ray photoelectron spectroscopy, a carbon distribution curve, indicating correlation between a distance from one surface of the gas barrier layer in a thickness direction of the gas barrier layer and a percentage of the carbon atoms (referred to as "carbon atom percentage (at%)") to total content (100 at%) of silicon, oxygen, and carbon atoms, shows extrema; and a difference between a highest extremum (local maximum) of the carbon atom percentage and a lowest extremum (local minimum) of the carbon atom percentage is 5 at% or greater;

Requirement (2): in an area of 90% or greater of an entire thickness of the gas barrier layer, the respective average percentage of the silicon, oxygen, and carbon atoms to the total content of the silicon, oxygen, and carbon atoms (100 at%) have a correlation defined by the following Inequality (A) or (B):

Inequality (A): (average carbon atom percentage) < (average silicon atom percentage) < (average oxygen atom percentage);
Inequality (B): (average oxygen atom percentage) < (average silicon atom percentage) < (average carbon atom percentage).

6. The method of manufacturing the gas barrier film according to aspect 5, wherein the gas barrier layer is formed through plasma-enhanced chemical vapor deposition which involves depositing a material gas containing organosilicon compounds and an oxygen gas in a discharge space of an applied magnetic field between rollers.
7. The method of manufacturing the gas barrier film according to aspect 5 or 6, wherein the contracting used in forming the inorganic polymer layer is by radiation of vacuum-ultraviolet light beams having a wavelength of 200 nm or less.

Advantageous Effects of Invention

The aspects according to the present invention described above can provide an electronic device including a gas barrier film exhibiting high gas-barrier properties and durability (flatness and dark-spot resistance) in the use in a high-temperature and high-humidity environment and a method of manufacturing such a gas barrier film.
Although all details of the technical mechanism providing objective advantageous effects of the present invention have not been clarified yet, they are presumed as described below.
A gas barrier film according to the present invention is mainly composed of a resin substrate, a gas barrier layer including oxygen atoms and carbon atoms with a composition continuously changing across the thickness of the gas barrier layer, and inorganic polymer layer.
Such a gas barrier layer disposed on the resin substrate and having elemental (atomic) distribution profiles continuously changing across the thickness of the gas barrier layer can exhibit high adhesion to the resin substrate and high flexibility, as well as high gas barrier properties. Unfortunately, an electronic device including a gas barrier film having such a gas barrier layer loses flatness because the layers of the gas barrier film have different contraction rates, and the contraction rate of the gas barrier layer is relatively higher than that of the resin substrate. Specifically, an electronic device including a resin film substrate having a thickness in a range of 15 to 150 $\mu$m is more prone to lose the flatness. The loss in flatness of the electronic device is remarkably observed specifically after being kept under a high-temperature and high-humidity environment for a long period. For instance, an organic electroluminescent device as an electronic device including such a gas barrier film may generate dark spots due to the loss in flatness, which leads to malfunction of the organic electroluminescent device.
The inventor of the present invention has eagerly examined these problems from several points of view, and has found that a gas barrier film which is a laminate of the gas barrier layer and an inorganic polymer layer having a predetermined contraction rate is resistant to the loss in the flatness, and that an electronic device including such a gas barrier film can exhibit high durability (flatness and dark-spot resistance).
In contrast, a gas barrier layer manufactured in a plasma discharge apparatus of a planar electrode (horizontal transfer) type cannot have a continuously changing concentration gradient of carbon atoms at the periphery of a resin substrate, and has a substantially homogeneous composition over the entire gas barrier layer. An electronic device including such a gas barrier layer having such a homogeneous elemental profile is also prone to loss in flatness. An organic electroluminescent device including such a gas barrier layer causes dark spots.
Even if the inorganic polymer layer having a contraction rate defined herein is laminated on the gas barrier layer having a substantially homogeneous elemental profile, the loss in flatness of an electronic device is unavoidable because of a difference in contraction between the gas barrier layer and the inorganic polymer layer: specifically, the contraction of the inorganic polymer layer having a predetermined contraction rate cannot compensate for the contraction of the gas barrier layer having a homogeneous elemental profile, and thus cannot prevent loss in flatness of the electronic device, but rather impairs the flatness of the gas barrier layer. This leads to significantly low durability of the electronic device.
In view of such problems of the conventional technology, the inventor of the present invention has found that the gas barrier film which is a laminate of a gas barrier layer having distribution profiles (of the elements in the gas barrier layer) continuously changing across the thickness and efficiently absorbing stress and an inorganic polymer layer having a predetermined contraction rate has high resistance to loss in its flatness, and that an electronic device including such a gas barrier film can exhibit high durability. Specifically, the gas barrier film according to the present invention can maintain high flatness after being kept under a high-temperature and high-humidity environment for a long period.

Brief Description of Drawings

Fig. 1 is a schematic cross-sectional view of a gas barrier film according to the present invention illustrating an exemplary basic structure of the gas barrier film.

Fig. 2 is a schematic view of a plasma-enhanced CVD apparatus including rollers defining a space to which a magnetic field is applied to generate plasma discharge, for an illustration of an exemplary method of manufacturing a gas barrier film according to the present invention.

Fig. 3 is a graph showing exemplary distribution curves of silicon, oxygen, and carbon atoms in a gas barrier layer according to the present invention.

Fig. 4 is a graph showing example distribution curves of silicon, oxygen, and carbon atoms in a gas barrier layer according to a comparative example.

Fig. 5 is a schematic view of an exemplary electronic device including a gas barrier film.

Embodiment for Carrying Out the Invention

An electronic device of the present invention includes a gas barrier film including, in sequence, a resin substrate, at least one gas barrier layer disposed on at least one surface of the resin substrate, and at least one inorganic polymer layer disposed on the at least one gas barrier layer. The gas barrier layer includes carbon atoms, silicon atoms, and oxygen atoms, and the composition continuously changes across the thickness. The gas barrier layer satisfies Requirements (1) and (2) described below. The inorganic polymer layer is composed of a polysilazane layer contracted into a contraction rate in a range of 10 to 30%.

Requirement (1): In the curves showing the elemental distribution across the depth of the gas barrier layer observed through X-ray photoelectron spectroscopy, the carbon distribution curve, indicating the correlation between the distance from one surface of the gas barrier layer across the thickness and the percentage of the carbon atoms (hereinafter referred to as "carbon atom percentage (at%)") to the total content (100 at%) of silicon, oxygen, and carbon atoms, shows extrema. The difference between the highest extremum (local maximum) and the lowest extremum (local minimum) of the carbon atom percentage is 5 at% or greater.

Requirement (2): In an area of 90% or greater of the entire thickness of the gas barrier layer, the respective average percentage of the silicon, oxygen, and carbon atoms to the total content of these elements (100 at%) have a correlation defined by the following Inequality (A) or (B).

Inequality (A): (average carbon atom percentage) < (average silicon atom percentage) < (average oxygen atom percentage);

Inequality (B): (average oxygen atom percentage) < (average silicon atom percentage) < (average carbon atom percentage).

This technical feature is common among Aspects 1 to 7 of the present invention.

In a preferred embodiment of the present invention, the average atomic percentage of the respective elements should have the correlation defined by Inequality (A), in order to efficiently achieve the advantageous effects of the present invention, i.e., production of an electronic device including a gas barrier film having high flatness and desirable gas barrier properties.

In a preferred embodiment of the present invention, the inorganic polymer layer should have a contraction rate in a range of 15 to 20% to produce an electronic device including a gas barrier film having high flatness (curl balance) and desirable gas barrier properties.

The gas barrier film of the present invention should preferably include a relatively thin resin substrate having a thickness in a range of 15 to 150 μm to certainly exhibit the advantageous effects of the present invention.

A method of manufacturing a gas barrier film to be used in an electronic device according to the present invention involves, in sequence, depositing a gas barrier layer on at least one surface of a resin substrate, and depositing an inorganic polymer layer on at least one of the gas barrier film. The gas barrier layer contains carbon, silicon, oxygen atoms, has a composition continuously changing across the thickness, and satisfies both Requirements (1) and (2). The inorganic polymer layer is formed by applying a polysilazane solution to form a coating layer onto the gas barrier layer, drying the coating layer, and contracting the dried coating layer into a contraction rate in a range of 10 to 30%.

The gas barrier film of the present invention should preferably be manufactured through plasma-enhanced chemical vapor deposition, which involves depositing a material gas containing organosilicon compounds while applying an oxygen gas in a discharge space of an applied magnetic field between rollers, in order to produce a gas barrier layer having desirable elemental profiles with high precision.

The method of manufacturing of the gas barrier film of the present invention should preferably involve contracting a coating layer by radiation of vacuum-ultraviolet light beams having a wavelength of 200 nm or less, in order to produce an inorganic polymer layer having a desirable contraction rate with high precision.
The term "gas barrier properties" herein represents a water vapor permeability of $3\times10^{-3}$ g/m$^2$ ·24h or less determined under the conditions (temperature: 60±0.5°C, relative humidity (RH) : 90±2%) in accordance with JIS K 7129-1992, and an oxygen permeability of $1\times10^{-3}$ ml/m$^2$·24h·atm or less determined in accordance with JIS K 7126-1987.
The terms "vacuum-ultraviolet light beams", "vacuum-ultraviolet light", "VUV", and "VUV light" used herein specifically refer to light having a wavelength of 100 to 200 nm.
Elements, embodiments, and aspects of the present invention will now be described in detail. It should be noted that the numerical values around the symbol "-" herein respectively represent a lower limit and an upper limit which are included in the range.

«Gas Barrier Film»

Fig. 1 is a schematic cross-sectional view of a gas barrier film according to the present invention illustrating an exemplary basic structure of the gas barrier film.
With reference to Fig. 1, the gas barrier film F of the present invention is a laminate of a resin substrate 1, a gas barrier layer 2 disposed on the resin substrate 1, and an inorganic polymer layer 3 disposed on the gas barrier layer 2.
The gas barrier layer 2 according to the present invention includes carbon, silicon, and oxygen atoms with the composition continuously changing across the thickness. The elemental distribution profiles satisfy both Requirements (1) and (2) described above. The inorganic polymer layer 3 of the present invention is formed by applying a polysilazane solution to form a coating layer, drying the coating layer, and then contracting the coating layer into a contraction rate in a range of 10 to 30% in the thickness direction.

[1] Resin Substrate

The resin substrate of the gas barrier film according to the present invention may be composed of any organic material that can support the gas barrier layer exhibiting gas barrier properties and the inorganic polymer layer.
Examples of the material applicable to the resin substrate of the present invention include resin films of methacrylate esters, poly(ethylene terephthalate) (PET), poly(ethylene naphthalate) (PEN), polycarbonates (PC), polyarylate, polystyrene (PS), aromatic polyamides, polyether ether ketones, polysulfones, polyether sulfones, polyimides, and polyether imides or laminates of at least two or more films selected from these resin films. Preferred are poly(ethylene terephthalate) (PET), poly(ethylene naphthalate) (PEN), and polycarbonates (PC) in view of their cost efficiency and high availability.
The resin substrate may have any thickness, preferably in a range of 15 to 150 μm, more preferably 20 to 100 μm, in order to efficiently achieve advantageous effects of the present invention.
As described above, the gas barrier layer of the present invention, which has a profile with the elemental composition continuously changing across the thickness (depth), may cause irregular changes in dimension (irregular changes in contraction rate) across the thickness of the gas barrier layer, which causes regional stress. To avoid the risk, a resin substrate having a thickness of 15 μm or greater is used to produce a gas barrier film that has desirable resistance to the stress from the gas barrier layer and can maintain high flatness. The use of a resin substrate having a thickness of 150 μm or less can achieve a thin gas barrier film and a thin electronic device including the thin gas barrier film. In addition, the resin substrate having a thickness of 150 μm or less has sufficient self-retention and can expand or contract in conjunction with the expansion or contraction of the gas barrier layer during the storage in a high-temperature and high-humidity environment. The use of such a resin substrate can produce a gas barrier film having high durability (film surface stability: flatness or resistance to cracks, for example). An organic EL device including such a gas barrier film having the properties according to the present invention exhibits high resistance to cracks and separation of the film, and occurrence of dark-spots on the device even under a high-temperature and high-humidity environment.
The resin substrate according to the present invention should preferably be a transparent substrate. A transparent gas barrier film can be formed by laminating transparent layers on the transparent resin substrate. The transparent resin substrate thus can be used in an electronic device, such as an organic EL device.
The resin substrate, which is composed of a resin selected from the components described above, may be a non-stretched film or stretched film. Preferred is a stretched film because of its high strength and high resistance to thermal expansion. The stretched film may be stretched to adjust the phase difference.
The resin substrate of the present invention may be manufactured through any known film-forming process. For example, a non-stretched and substantially amorphous resin substrate may be manufactured by extrusion of a melted resin material through a T-die or circular die of an extruder, and then rapidly cooling the extruded film. Such a non-stretched and substantially amorphous resin substrate can also be manufactured through casting of a solution

containing a resin material onto an endless metal support, drying of the cast film, and detachment of the resulting substrate.

The non-stretched resin substrate may be stretched in a machine direction (also referred to as a longitudinal axis direction or MD) of the resin substrate or in a transverse direction (also referred to as a lateral axis direction or TD) orthogonal to the machine direction of the resin substrate, through any known process, for example, uniaxial stretching, sequential biaxial stretching with a tenter, simultaneous biaxial stretching with a tenter, or simultaneous biaxial stretching with a tubular. With this, a stretched resin material can be manufactured. In these processes, the stretching ratio may be appropriately determined depending on a resin material of the resin substrate. The stretching ratio should preferably be in a range of 2 to 10 times in the machine direction (MD) and transverse direction (TD).

The resin substrate of the present invention may be subjected to a relaxation and an off-line heat treatment for enhancing the dimensional stability of the resin substrate. The relaxation should preferably be conducted after thermal fixation in the stretching step of the film-forming process described above; during the presence of the substrate in a lateral stretching tenter; or after the transfer of the substrate through the tenter and before the roll-up of the substrate. The relaxation should preferably be conducted at a temperature in a range of 80 to 200°C, more preferably 100 to 180°C. The resin substrate to be subjected to the off-line thermal treatment may be conveyed by any conveying process; for example, roller conveyance using multiple rollers, air conveyance involving air blow to the film substrate to float the film substrate (specifically, blowing in heated air through multiple slits to one or two surfaces of the film substrate), radiant-heat conveyance with an infrared heater, or roll-up of the film substrate hanging down under its own weight. The conveyance tension during the thermal treatment is set to be as low as possible to accelerate thermal contraction of the resin substrate. This can produce a resin substrate having high dimensional stability. The thermal treatment should be conducted at a temperature in a range of Tg + 50°C to Tg + 150°C. The abbreviation "Tg" used herein refers to a glass transition temperature of the resin substrate.

During an in-line step of the film-forming process, one or two surfaces of the resin substrate of the present invention maybe applied with an undercoating solution. Such an undercoating step in the film-forming process described herein is referred to as "in-line undercoating". Preferred examples of a resin contained in the undercoating solution applicable to the present invention include polyester resins, acrylic modified polyester resins, polyurethane resins, acrylic resins, vinyl resins, vinylidene chloride resins, polyethylene-imine-vinylidene resins, polyethylene-imine resins, poly(vinyl alcohol) resins, modified poly(vinyl alcohol) resins, and gelatin. The undercoating solution may contain conventional additives. The undercoating layer may be formed through any known coating process, for example, roller coating, gravure coating, knife coating, dip coating, or spray coating. The amount of the undercoating solution applied to the resin substrate should preferably be in a range of 0.01g/m$^2$ to 2g/m$^2$ (in a dried state).

[2] Gas Barrier Layer

The gas barrier layer according to the present invention contains carbon, silicon, and oxygen atoms, the composition continuously changes across the thickness, and satisfies both Requirements (1) and (2):

Requirement (1): in the curves showing the elemental distribution across the depth of the gas barrier layer observed through X-ray photoelectron spectroscopy based on elemental distribution measurement, the carbon distribution curve, indicating the correlation between the distance from one surface of the gas barrier layer in the thickness direction of the gas barrier and the rate of the carbon atoms (hereinafter referred to as "carbon atom percentage (at%)") to the total content (100 at%) of silicon, oxygen, and carbon atoms, shows extrema; and the difference between the highest extremum (local maximum) of the carbon atom percentage and the lowest extremum (local minimum) of the carbon atom percentage is 5 at% or greater;

Requirement (2): in an area of 90% or greater of the entire thickness of the gas barrier layer, the respective average percentage of the silicon, oxygen, and carbon atoms to the total content of these elements (100 at%) have a correlation defined by the following Inequality (A) or (B);

Inequality (A): (average carbon atom content) < (average silicon atom content) < (average oxygen atom content);
Inequality (B): (average oxygen atom content) < (average silicon atom content) < (average carbon atom content).

In a preferred embodiment, an area in a range of 90% to 95% of the entire thickness of the gas barrier layer should satisfy Inequalities (A) or (B), taking into account of reduced precision in a measurement on the interfacial region of the substrate due to the noise from elements in the substrate.

The gas barrier layer having a configuration defined above may be formed through the process described in WO2012/046767 (Patent Literature 1).

In a preferred embodiment, the gas barrier layer of the present invention should have a thickness in a range of 50 to 1000 nm. The gas barrier layer according to the present invention may be formed through any film-forming process that can achieve the elemental profiles defined herein. Preferred is plasma-enhanced chemical vapor deposition which involves depositing a material gas containing organosilicon compounds while applying an oxygen gas in a discharge

space of an applied magnetic field between rollers, in order to produce a gas barrier layer having elemental distributions strictly controlled.

The gas barrier layer according to the present invention will now be described in detail.

In the present invention, the average carbon atom percentage in the gas barrier layer may be measured through XPS depth profile analysis described below.

The gas barrier layer according to the present invention will now be described in detail.

(2.1) Carbon Elemental Profile in Gas Barrier Layer

One of the characteristics of the gas barrier layer according to the present invention lies in that the gas barrier layer contains carbon, silicon, and oxygen atoms as composition elements, the composition continuously changes across the thickness; in the curves showing the elemental distribution across the depth of the gas barrier layer observed through X-ray photoelectron spectroscopy based on elemental distribution measurement, the carbon distribution curve, indicating the correlation between the distance from one surface of the gas barrier layer in the thickness direction of the gas barrier layer and the percentage of the content of carbon atoms (hereinafter referred to as "carbon atom percentage (at%)") to the total content (100 at%) of silicon, oxygen, and carbon atoms, shows extrema; and the difference between the highest extremum (local maximum) of the carbon atom percentage and the lowest extremum (local minimum) of the carbon atom percentage is 5 at% or greater.

The gas barrier layer according to the present invention should preferably have a carbon atom percentage showing continuously changing concentration gradient in a predetermined region of the gas barrier layer to exhibit high gas barrier properties and high flexibility.

In the gas barrier layer according to the present invention having such a carbon distribution profile, the carbon distribution curve observed in the gas barrier layer has at least one extremum, preferably at least two extrema, more preferably at least three extrema. A gas barrier film which includes a gas barrier layer showing no extremum in the carbon distribution curve exhibits low gas barrier properties while being bent. If the carbon distribution curve has at least two or three extrema, the absolute difference between the distance of one extremum from one surface of the gas barrier layer in the thickness direction of the gas barrier layer and that of an adjacent extremum should preferably be 200 nm or less, more preferably 100 nm or less.

The term "extremum" (or "extrema") of distribution curves used herein refers to a local maximum and a local minimum of the percentage of the atom of the elements in the gas barrier layer relative to the distance from one surface of the gas barrier layer in the thickness direction of the gas barrier layer.

The term "local maximum" used herein refers to an inflection point at which the atomic percentage of an element shifts from increase to decrease along the depth from one surface of the gas barrier layer; specifically, the atomic percentage of the element at a point 20 nm deeper than the inflection point in the thickness is less than that at the inflection point by 3 at% or greater.

The term "local minimum" used herein refers to an inflection point at which the atomic ratio of an element shifts from decrease to increase along the depth from one surface of the gas barrier layer; specifically, the atomic percentage of the element at a point 20 nm deeper than the inflection point in the thickness is higher than that at the inflection point by 3 at% or greater.

The gas barrier layer according to the present invention shows extrema, and the difference between the highest extremum (local maximum) of the carbon atom percentage and the lowest extremum (local minimum) of the carbon atom percentage is 5 at% or greater.

(2.2) Elemental Profiles in Gas Barrier Layer

The gas barrier layer according to the present invention contains carbon, silicon, and oxygen atoms as composition elements. Preferred atomic percentage and preferred embodiments of the highest value and lowest value of these elements will now be described.

<2.2.1> Correlation between Highest value and Lowest value of Carbon Atom Percentage

The carbon distribution curve observed in the gas barrier layer according to the present invention shows the highest extremum (local maximum) of the carbon atom percentage higher than the lowest extremum (local minimum) of the carbon atom content by 5 at% or greater. In such a gas barrier layer, the absolute difference between the highest value and the lowest value of the carbon atom percentage should preferably be 6 at% or greater, particularly preferably 7 at% or greater. A gas barrier film including such a gas barrier layer with a difference of 5 at% or greater between the highest value and the lowest value of the carbon atom percentage can exhibit sufficiently high gas barrier properties while being bent.

<2.2.2> Correlation between Highest value of Oxygen Atom Percentage and Lowest value of Oxygen Atom Percentage

In the oxygen distribution curve observed in the gas barrier layer according to the present invention, the absolute difference between the highest value and the lowest value of the oxygen atom percentage should preferably be 5 at% or greater, more preferably 6 at% or greater, particularly preferably 7 at% or greater. A gas barrier film including such a gas barrier layer with an absolute difference of 5 at% or greater can exhibit sufficiently high gas barrier properties while being bent.

<2.2.3> Correlation between Highest value and Lowest value of Silicon Atom Percentage

In the silicon distribution curve observed in the gas barrier layer according to the present invention, the absolute difference between the highest value and the lowest value of the silicon atom content should preferably be less than 5 at%, more preferably less than 4 at%, particularly preferably less than 3 at%. A gas barrier film including such a gas barrier layer with an absolute difference of less than 5 at% can exhibit sufficiently high gas barrier properties and mechanical strength.

<2.2.4> Percentage of Total Amount of Oxygen Atoms and Carbon Atoms

In the distribution curve of total amount of oxygen and carbon atoms (also referred to as oxygen-carbon distribution curve) observed in the gas barrier layer according to the present invention, which depicts the correlation between the depth from one surface of the gas barrier layer and the percentage of the total content of oxygen and carbon atoms (also referred to as oxygen-carbon atom percentage) to the total content of silicon, oxygen, and carbon atoms, the absolute difference between the highest value and the lowest value of the oxygen-carbon atom percentage should preferably be less than 5 at%, more preferably less than 4 at%, particularly preferably less than 3 at%. A gas barrier film including such a gas barrier layer with an absolute difference less than 5 at% can exhibit sufficiently high gas barrier properties.

In the description of the carbon atom distribution profile (or silicon, oxygen, carbon distribution curves) illustrated in Figs. 3 and 4, which will be described below, the term "total content of silicon, oxygen, and carbon atoms" refers to a total at% of silicon, oxygen, and carbon atoms, and the term "carbon atom content" refers to the atomic number of carbon atoms. The term "at%" used herein represents the atomic percentage (atomic number %) of silicon, oxygen, or carbon atoms to the total content (100%) of these elements. The same explanation can be applied to the terms "silicon atom content" and "oxygen atom content" in the description of the silicon, oxygen, and oxygen-carbon distribution curves illustrated in Figs. 3 and 4.

<2.2.5> Elemental Distribution over Entire Gas Barrier Layer from Surface across Thickness

In an area of 90% or greater of the entire thickness of the gas barrier layer according to the present invention, the respective average percentage of the silicon, oxygen, and carbon atoms to the total content of these elements (100 at%) have a correlation defined by the following Inequality (A) or (B) :

Inequality (A): (average carbon atom percentage) < (average silicon atom percentage) < (average oxygen atom percentage);

Inequality (B): (average oxygen atom percentage) < (average silicon atom percentage) < (average carbon atom percentage).

(2.3) Measurement of Elemental Distribution across Depth through X-ray photoelectron spectroscopy

The curves depicting silicon, oxygen, carbon, and oxygen-carbon distribution profiles in the gas barrier layer across the thickness can be observed through X-ray photoelectron spectroscopic (XPS) depth profile analysis, which

involves the XPS measurement and ion sputtering with rare gases, such as argon, to expose the internal regions of a sample to sequentially analyze the composition of the surface. The distribution curves observed through the XPS depth profile analysis can be shown as a function of atomic percentage (at%) of the elements on the vertical axis and etching (sputtering) period on the horizontal axis, for example. In such an elemental distribution curve, a period required to etch a predetermined thickness of the gas barrier layer, shown in the horizontal axis, substantially depends on the depth from one surface of the gas barrier layer. Accordingly, the distance from the surface of the gas barrier layer calculated from the correlation between the etching rate and etching period in the XPS depth profile analysis can be employed as "the distance from one surface of the gas barrier layer in the thickness direction". The sputtering process in the XPS depth profile analysis should preferably be conducted with rare-gas ions, such as argon ($AR^+$), and have an etching rate of 0.05 nm/sec (equivalent to $SiO_2$ thermal oxide film).

In a preferred embodiment of the present invention, the gas barrier layer should have a substantially homogeneous profile over the film plane (a direction parallel to the surface of the gas barrier layer) to exhibit high gas barrier properties uniform over the film surface. In the gas barrier layer having a substantially homogeneous profile over the film plane of the present invention, two oxygen distribution curves, two carbon distribution curves, and two oxygen-carbon distribution curves which are observed at two predetermined regions on the film plane through XPS depth profile analysis, respectively have the same number of extrema, and the two carbon distribution curves have the same absolute difference between the highest value and the lowest value of the carbon atom percentage or a difference of 5% or less in absolute difference between the highest value and the lowest value of the carbon atom content.

The gas barrier film according to the present invention essentially includes at least one gas barrier layer satisfying both Requirement (1) and (2) defined herein. The gas barrier film according to the present invention may include two or more gas barrier layers satisfying both Requirements (1) and (2). In the gas barrier film including two or more gas barrier layers satisfying both Requirements (1) and (2), these gas barrier layers may be composed of the same material or different materials. The two or more gas barrier layers may be disposed on one or two surfaces of the substrate. At least one of the two or more gas barrier layers may be replaced with a substantial non-gas-barrier layer.

In the silicon distribution curve described above, the silicon atom percentage to the total content of the silicon, oxygen, and carbon atoms should preferably be in a range of 19 to 40 at%, more preferably 30 to 40 at%. In the oxygen distribution curve of the gas barrier layer described above, the oxygen atom percentage to the total content of the silicon, oxygen, and carbon atoms should preferably be in a range of 33 to 67 at%, more preferably 41 to 62 at%. In the carbon distribution curve of the gas barrier layer described above, the carbon atom percentage to the total content of the silicon, oxygen, and carbon atoms should preferably be in a range of 1 to 19 at%, more preferably 3 to 19 at%.

(2.4) Thickness of Gas Barrier Layer

The gas barrier layer according to the present invention should preferably have a thickness in a range of 5 to 1000 nm, more preferably 10 to 1000 nm, particularly preferably 100 to 1000 nm. The gas barrier layer having a thickness in such a range can exhibit high gas barrier properties against oxygen and moisture vapor, for example, and maintain the gas barrier properties while being bent.

The gas barrier layer having the entire thickness within the range can exhibit desired flatness, sufficiently high gas barrier properties against oxygen and moisture vapor, for example, and can maintain the high gas barrier properties while being bent.

(2.5) Method of Forming Gas Barrier Layer

The gas barrier layer according to the present invention may be formed through any film-forming process that can achieve the elemental profiles defined herein. Preferred is plasma-enhanced discharge chemical vapor deposition which involves depositing a material gas containing organosilicon compounds while applying an oxygen gas in a discharge space of an applied magnetic field between rollers, in order to produce a gas barrier layer having elemental distributions strictly controlled.

To be more specific, the gas barrier layer according to the present invention is formed on a resin substrate, which is disposed around a pair of film-forming rollers in a processing apparatus, through plasma-enhanced chemical vapor deposition, which involves applying a film-forming gas to a magnetic field between the film-forming rollers, while generating plasma discharge in the magnetic field. During the generation of the plasma discharge in the magnetic field between the film-forming rollers, the polarities of the film-forming rollers should preferably be alternately inverted. In the plasma-enhanced chemical vapor deposition, a material gas containing organosilicon compounds and an oxygen gas should preferably be used as a film-forming gas. The film-forming gas should preferably include the oxygen gas in an amount not greater than a theoretical amount required for oxidizing all organosilicon compounds in the film-forming gas. The gas barrier layer of the gas barrier film according to the present invention should preferably be formed by continuous film-forming processes.

Specific processes of forming a gas barrier layer according to the present invention will now be described.

The gas barrier film according to the present invention is manufactured by forming a gas barrier layer on a resin substrate in a plasma processing apparatus including rollers defining a space to which a magnetic field is applied to generate plasma discharge therein. (An optional interlayer may be formed between the substrate and the gas barrier layer).

The gas barrier layer of the present invention should preferably be formed through plasma discharge chemical vapor deposition in a discharge space of an applied magnetic field between rollers, in order to exhibit a concentration gradient and a continuous change in the percentage of the carbon atoms in the gas barrier layer.

The plasma discharge chemical vapor deposition (hereinafter also referred to as plasma CVD or roller CVD) applicable to the present invention should preferably involve applying a magnetic field to a discharge space between a pair of film-forming rollers to generate plasma discharge therein. In a preferred embodiment of the present invention, the plasma discharge should be generated in the magnetic field between the film-forming rollers that have a resin substrate there around. Such a plasma discharge process, which involves generating the plasma discharge in the magnetic field between the film-forming rollers having a resin substrate there around, is able to change the distance between the resin substrate and the film-forming rollers, which can produce a gas barrier layer exhibiting a concentration gradient and a continuous change in the percentage of the carbon atoms in the gas barrier layer.

In such a plasma discharge process, film formation on the resin substrate can be conducted simultaneously on both of the film-forming rollers, with high efficiency, i.e., double film-forming rate. This can produce a gas barrier layer having a uniform configuration over the entire surface, and showing at least double the number of extrema in the carbon distribution curve. Accordingly, the gas barrier layer satisfying both Requirements (1) and (2) described above can be formed with high efficiency.

The gas barrier film according to the present invention should preferably be produced by forming the gas barrier layer on the substrate through a roll-to-roll process, in view of its high productivity.

The gas barrier film may be manufactured in any apparatus employing such plasma-enhanced chemical vapor deposition method. The plasma-enhanced CVD apparatus should preferably include at least two film-forming rollers in a pair having devices from which a magnetic field is applied to a space between the film-forming rollers and a plasma power source, to generate plasma discharge in the space between the two film-forming rollers. For example, the manufacturing apparatus illustrated in Fig. 2 can form a gas barrier film through plasma-enhanced chemical vapor deposition involving a roll-to-roll process.

<2.5.1> Plasma-Enhanced CVD Apparatus Having Rollers Generating Plasma Discharge

A method of manufacturing a gas barrier film according to the present invention will now be described in detail with reference to Fig. 2. Fig. 2 is a schematic view of an exemplary plasma-enhanced CVD apparatus including rollers defining a space to which a magnetic field is applied to generate plasma discharge which can be appropriately applied to the production of the gas barrier film according to the present invention.

With reference to Fig. 2, the plasma-enhanced CVD apparatus including rollers defining a space to which a magnetic field is applied to generate plasma discharge (hereinafter simply referred to as plasma-enhanced CVD apparatus) includes, as primary components, a delivering roller 11, transferring rollers 21, 22, 23, and 24, film-forming rollers 31 and 32, a film-forming gas feeder 41, a plasma-generating power source 51, magnetic-field generators 61 and 62 respectively disposed in the film-forming rollers 31 and 32, and a take-up roller 71. In such a plasma-enhanced CVD apparatus, at least the film-forming rollers 31 and 32, film-forming gas feeder 41, plasma-generating power source 51, and magnetic-field generators 61 and 62 are accommodated in a vacuum chamber, which is not shown in the drawing. The vacuum chamber (not shown) of the plasma-enhanced CVD apparatus is connected to a vacuum pump (not shown) which can appropriately control the pressure in the vacuum chamber.

In the plasma-enhanced CVD apparatus, the paired film-forming rollers 31 and 32 are connected to the plasma-generating power source 51 so as to function as counter electrodes. Electric power supply from the plasma-generating power source 51 to the paired film-forming rollers 31 and 32 can cause electric discharge in a space between the film-forming rollers 31 and 32. This can generate plasma in the space (or discharge space) between the film-forming rollers 31 and 32. The film-forming rollers 31 and 32 may be composed of any material and any structure that are applicable to electrodes. In the plasma-enhanced CVD apparatus, the paired film-forming rollers 31 and 32 should preferably be disposed such that the central axes thereof are substantially parallel to each other on the same plane. The paired film-forming rollers 31 and 32 having such a configuration can double a film-forming rate while forming a film having a uniform structure. This can increase the value of extrema in the carbon distribution curve by twice, at least.

The magnetic-field generators 61 and 62 are respectively fixed in the film-forming rollers 31 and 32 so as not to rotate in conjunction with the rotation of the film-forming rollers 31 and 32.

The film-forming rollers 31 and 32 may be known appropriate rollers. The film-forming rollers 31 and 32 should preferably have the same diameter to form a thin film with high efficiency. The film-forming rollers 31 and 32 should

preferably have a diameter in a range of 100 to 1000 mm, more preferably 100 to 700 mm, taking into account of the discharge conditions and the space in the chamber.
Film-forming rollers having a diameter of 100 mm or greater can form a relatively large plasma discharge space. This can maintain productivity of the film forming apparatus, and can prevent the resulting film from undergoing the total heat of the plasma discharge in a short time, resulting in a reduced residual stress. A practical film-forming apparatus can be designed and produced in consideration of a uniform plasma discharge space with film-forming rollers having a diameter of 1000 mm or less.

The delivering roller 11 and the transferring rollers 21, 22, 23, and 24 of the plasma-enhanced CVD apparatus may be known appropriate rollers. In addition, the take-up roller 71 may be any known appropriate roller that can wind the resin substrate 1 having a gas barrier layer thereon.

The film-forming gas feeder 41 may be any appropriate device that can supply or discharge a material gas and an oxygen gas at a predetermined rate. The plasma-generating power source 51 may be any known power source for a conventional plasma generating device. The plasma-generating power source 51 supplies electricity to the film-forming rollers 31 and 32 that are in connection with the plasma-generating power source 51, so that the film-forming rollers 31 and 32 can function as counter electrodes to cause electric discharge. In a preferred embodiment, the plasma-generating power source 51 should be able to alternately invert the polarities of the paired film-forming rollers to conduct plasma-enhanced CVD with high efficiency (for example, an AC power source). In a more preferred embodiment, the plasma-generating power source 51 should be able to supply electricity in a range of 100 W to 10 kW and an alternate current having a frequency in a range of 50 Hz to 500 kHz. The magnetic-field generators 61 and 62 may be any known appropriate device that can generate a magnetic field.

A gas barrier film according to the present invention can be manufactured in the plasma-enhanced CVD apparatus illustrated in Fig. 2, through appropriate selection of a type of a material gas, electricity to electrode drums of a plasma generating device, an intensity of the magnetic-field generators, a pressure (reduction in pressure) in the vacuum chamber, the diameter of the film-forming roller, and a transfer rate of the resin substrate. Specifically, a film-forming gas (e.g., material gas) is supplied in the vacuum chamber in the plasma-enhanced CVD apparatus illustrated in Fig. 2, and is decomposed by plasma discharge caused in the magnetic field generated in a space between the paired film-forming rollers 31 and 32, so that a gas barrier layer according to the present invention is formed through plasma-enhanced CVD on two regions of the resin substrate 1 respectively supported by the film-forming roller 31 and the film-forming roller 32. In such a film-forming process, the gas barrier layer is continuously formed on the resin substrate 1 through a roll-to-roll process which involves transferring the resin substrate 1 with the delivering roller 11 and the film-forming roller 31.

<2.5.2> Material Gas

The material gas used as a film-forming gas to form a gas barrier layer according to the present invention should preferably contain organosilicon compounds, which contains at least silicon atoms.

Preferred examples of the organosilicon compound applicable to the present invention include hexamethyldisiloxane, 1,1,3,3-tetramethyldisiloxane, trimethylvinylsilane, methyltrimethylsilane, hexamethyldisilane, methylsilane, dimethylsilane, trimethylsilane, diethylsilane, propylsilane, phenylsilane, vinyltriethoxysilane, vinyltrimethoxysilane, tetramethoxysilane, tetraethoxysilane, phenyltrimethoxysilane, methyltriethoxysilane, and octamethylcyclotetrasiloxane. Among these organosilicon compounds, preferred are hexamethyldisiloxane and 1,1,3,3-tetramethyldisiloxane, in view of their usability in the film forming process and gas barrier properties of the resulting gas barrier layer. These organosilicon compounds may be used alone or in combination.

The film forming gas contains oxygen gas functioning as a reactant gas, in addition to the material gas. The oxygen gas is reacted with the material gas to form inorganic compounds, such as oxides.

The film-forming gas may contain as necessary a carrier gas to supply the material gas into the vacuum chamber. The film-forming gas may contain as necessary a discharge gas to cause plasma discharge. These carrier gas and discharge gas may be composed of known appropriate gases; for example, rare gases, such as helium, argon, neon, and xenon, or hydrogen gas.

If the film-forming gas is composed of a material gas including organosilicon compounds containing silicon atoms and oxygen gas, the ratio of the oxygen gas to the material gas should not preferably be much greater than a theoretical ratio required for complete reaction of the material gas with the oxygen gas. An oxygen gas having a ratio much greater than the theoretical ratio may lead to a failure in the production of the gas barrier layer of the present invention. The ratio of the oxygen gas thus should preferably be not greater than the theoretical ratio required for oxidizing all organosilicon compounds in the film-forming gas to achieve desired gas barrier properties of the film.

A system of hexamethyldisiloxane (organosilicon compound (HMDSO: $(CH_3)_6Si_2O$) and oxygen ($O_2$) will now be described as a typical example of the material gas and reactant gas.

The film-forming gas including the hexamethyldisiloxane (organosilicon compound: HMDSO: $(CH_3)_6Si_2O$)

functioning as a material gas and the oxygen ($O_2$) functioning as a reactant gas is reacted through the plasma-enhanced CVD to form a film having a silicon-oxygen system. In such a case, the film-forming gas causes the reaction represented by Formula (1) and a film composed of silicon dioxide $SiO_2$ is formed.

Formula (1) : $(CH_3)_6Si_2O+12O_2 \rightarrow 6CO_2+9H_2O+2SiO_2$

In the reaction, 12 mol of oxygen is required for complete oxidation of 1 mol of hexamethyldisiloxane. After the complete oxidation of 1 mol of hexamethyldisiloxane in the presence of 12 mol or more of oxygen in the film-forming gas, the resulting film may have a uniform distribution of silicon dioxide. To cause incomplete oxidation, the flow rate of the material gas is controlled so as not to be greater than a theoretical rate required for the complete oxidation. Specifically, the ratio of oxygen should be less than the stoichiometric ratio, i.e., 12 mol relative to 1 mol of hexamethyldisiloxane.

In the actual situation, hexamethyldisiloxane functioning as a material gas and oxygen functioning as a reactant gas are supplied from the gas feeder to a film-forming region to form a film in the chamber of the plasma CVD apparatus. In such a situation, the oxygen (functioning as a reactant gas) having a molar (flow) quantity of 12 times the molar (flow) quantity of hexamethyldisiloxane (functioning as a material gas) actually cannot completely oxidize the hexamethyldisiloxane. A complete oxidation can be achieved only by supplying oxygen having a ratio much greater than the stoichiometric ratio. For example, the molar (flow) quantity of oxygen may be around 20 or more times to the molar (flow) quantity of the hexamethyldisiloxane as material gas to cause the complete oxidation in the CVD process in order to produce silicon oxide. The molar (flow) quantity of the oxygen to the molar (flow) quantity of the hexamethyldisiloxane material thus should preferably be equal to the stoichiometric ratio, i.e., 12 times or less, more preferably 10 times or less. The film-forming gas including hexamethyldisiloxane and oxygen in such a proportion can form a gas barrier layer containing incompletely oxidized carbon and hydrogen atoms of hexamethyldisiloxane to exhibit desired properties. The gas barrier film including such a gas barrier layer can exhibit high gas barrier properties and high flexibility. The use of a film-forming gas having an insufficient oxygen molar (flow) quantity relative to the hexamethyldisiloxane molar (flow) quantity leads to a gas barrier layer containing excess amount of unoxidized carbon atoms and hydrogen atoms. This leads to a decrease in transparency of the gas barrier layer. The gas barrier film including such a gas barrier layer cannot be used as a flexible substrate in electronic devices, for example, organic EL devices or organic film solar cells, which should have high transparency. In view of such circumstances, the lower limit of the molar (flow) quantity of oxygen to the molar (flow) quantity of hexamethyldisiloxane in the film-forming gas should preferably be greater than 0.1 times, more preferably greater than 0.5 times the molar (flow) quantity of hexamethyldisiloxane.

<2.5.3> Degree of Vacuum

The pressure (degree of vacuum) in the vacuum chamber may appropriately be controlled depending on a type of the material gas, and should preferably be in a range of 0.5 to 100 Pa.

<2.5.4> Film Formation with Rollers

In plasma-enhanced CVD method using the plasma-enhanced CVD apparatus illustrated in Fig. 2, electric power to be applied to the electrode drums (respectively disposed in the film-forming rollers 31 and 32 in Fig. 2) in connection with the plasma-generating power source 51 can appropriately be controlled depending on a type of the material gas and pressure in the vacuum chamber, in order to generate electric discharge between the film-forming rollers 31 and 32. A preferred level of the power should be in a range of 0.1 to 10 kW. Application of power in such a range does not cause generation of particles (contaminants) and can generate a thermal energy within a controlled range during the film forming process. This prevents thermal deformation of the resin substrate due to an increase in temperature of the surface of the substrate during the film forming process, and low performance and crease of the resulting film caused by high thermal energy. Such thermal energy within a controlled range prevents damages on the film-forming rollers which are caused by overcurrent discharge between the bare film-forming rollers after the resin substrate is melted with heat.

The transfer rate or line speed of the resin substrate 1 can appropriately be controlled depending on the type of the material gas and the pressure in the vacuum chamber, and should preferably be in a range of 0.25 to 100 m/min, more preferably 0.5 to 20 m/min. The resin substrate transferred at a line speed within the predetermined range described above is resistant to creases caused by heat applied on the resin substrate 1 and thus the thickness of the resulting gas barrier layer can be sufficiently controlled.

<2.5.5> Elemental Profile of Gas Barrier Layer

Exemplary elemental profiles across the thickness of the gas barrier layer of the present invention, which is

formed through the processes described above, are observed through XPS depth profile analysis and are shown in Fig. 3.

Fig. 3 is a graph showing exemplary distribution curves of silicon, oxygen, and carbon atoms of the gas barrier layer according to the present invention.

Fig. 3 illustrates a carbon distribution curve A, silicon distribution curve B, oxygen distribution curve C, and oxygen-carbon distribution curve D. As shown in the graph of Fig. 3, the gas barrier layer according to the present invention exhibits extrema. The difference between the highest value and the lowest value of the carbon atom percentage is 5 at% or greater. In an area of 90% or greater of the entire thickness of the gas barrier layer, the respective average percentage of the silicon, oxygen, and carbon atoms to the total content of these elements (100 at%) have a correlation defined by Inequality (A) or (B) described above.

Fig. 4 is a graph showing a carbon distribution curve A, a silicon distribution curve B, and an oxygen distribution curve of a comparative gas barrier layer.

The carbon atom profile A, the silicon atom profile B, and the oxygen atom profile C are observed in the comparative gas barrier layer, which is manufactured in a discharge method of a planar electrode (horizontal transfer) type for plasma-enhanced CVD. Specifically, the carbon atom component A demonstrates that a continuous change in concentration gradient of the carbon atoms is not observed.

[3] Inorganic Polymer Layer

A method of manufacturing a gas barrier film according to the present invention involves applying a polysilazane solution to form a coating layer on the gas barrier layer described above, drying the coating layer, and then contracting the coating layer into a contraction rate in a range of 10 to 30% in the thickness direction to form an inorganic polymer layer. The contraction rate is preferably within a range of 15 to 20%.

As described above, the gas barrier layer of the present invention, with a profile in which elemental composition continuously changes across the thickness (depth), may cause irregular changes in dimension (irregular changes in contraction rate) across the thickness of the gas barrier layer, which causes a regional stress; however, formation of an inorganic polymer layer having a contraction rate in a range of 10 to 30% on the gas barrier layer can compensate for the stress generated in the gas barrier layer, so that the resulting gas barrier layer thus can maintain high flatness. Specifically, an inorganic polymer layer having a contraction rate of 10% or greater in the thickness direction can sufficiently compensate for the stress caused in the gas barrier layer. An inorganic polymer layer having a contraction rate of 30% or less can generate stress that can prevent the occurrence of cracks and separation of the underlying gas barrier layer. An electronic device including the gas barrier film according to the present invention can maintain the properties described above, and exhibit high resistance to dark-spots.

The thickness of the inorganic polymer layer according to the present invention should preferably be in a range of 50 to 500 nm after the contraction.

In the present invention, the inorganic polymer layer is formed by applying a polysilazane solution to form a coating layer onto the gas barrier layer according to the present invention through a wet application process, drying the coating layer, and contracting the coating layer.

The inorganic polymer layer of the present invention may be contracted through any process that can contract a target layer into a contraction rate in a range of 10 to 30% in the thickness direction. The contraction may be conducted through, for example, plasma-enhanced CVD, ion implantation, ultraviolet irradiation, vacuum ultraviolet irradiation, or thermal processing that can modify the polysilazane layer. Among them, preferred is a process which involves applying a polysilazane solution to form a coating layer onto the gas barrier layer, drying the coating layer, and contracting the coating layer with vacuum ultraviolet (VUV) beams having a wavelength of 200 nm or less to form the inorganic polymer layer according to the present invention.

(3.1) Measurement for Contraction Rate of Film

In the present invention, the contraction rate of the inorganic polymer layer by the contraction can be determined through Measurements 1 or 2 described below. Preferred is Measurement 2.

(Measurement 1)

The polysilazane solution is applied with a wireless bar to form a coating layer such that the dried coating layer has a (average) thickness of 300 nm. The coating layer is dried in an atmosphere of 85°C and RH of 55% for one minute, is left to stand in an atmosphere of 25°C and RH of 10% (dew-point temperature -8°C) for ten minutes, and is then dehumidified. The resulting layer is named Sample A.

The polysilazane layer of Sample A produced through the process described above is placed in a vacuum chamber of an ultraviolet irradiator, which is described below, and is then contracted under a controlled pressure in the

ultraviolet irradiator. Sample A after the contraction is named Sample B.

<Ultraviolet Irradiator>

Device: Excimer UV lamp available from M.D.COM, Inc
MODEL: MECL-M-1-200
UV Wavelength: 172 nm
Lamp Filler Gas: Xe

<Conditions for Contraction>

A substrate formed with the polysilazane layer is fixed onto an operation stage and contraction is performed under the conditions described below to form an inorganic polymer layer.

Light Intensity of Excimer Lamp: 130 mW/cm$^2$ (172 nm)
Distance between Sample and Light Source: 1 mm
Heating Temperature of Stage: 70°C
Oxygen Concentration in Irradiator: 1.0%
Irradiation Time by Excimer Lamp: 5 seconds

<Measurement for Film Contraction Rate>

The thickness of the polysilazane layer of Sample A (before the contraction) and the thickness of the inorganic polymer layer of Sample B (after the contraction) are measured in accordance with the following processes.

<Cross-Sectional TEM Observation>

The sample to be observed is processed into sample pieces with an FIB apparatus described below, and the sample pieces are subjected to a TEM observation.

<FIB Treatment>

Device: SMI2050 available from SII
Ion for Processing: (Ga 30kV)
Thickness of Sample Piece: 200 nm
<TEM Observation>
Device: JEM2000FX (Accelerating Voltage: 200 kV) available from JEOL Ltd.
Electron Beam Irradiation Time: 30 seconds

The contraction rate is measured through the following processes.

$$\text{Contraction Rate (\%)} = [\{(\text{thickness of Sample A}) - (\text{thickness of Sample B})\} / \text{thickness of Sample A}] \times 100(\%)$$

(Measurement 2)

The contraction rate of the inorganic polymer layer formed after the contraction can be measured through the following processes.

The contracted inorganic polymer layer is subjected to the TEM observation as in Measurement 1 described above. The cross-sectional image of the inorganic polymer layer observed through the TEM observation shows contracted portions in a deep color and non-contracted portions in a light color. The thickness of the deep-colored (contracted)

portions and the thickness of the light-colored (non-contracted) portions are measured to determine the contraction rate (%) in accordance with the following expressions.

$$\text{Contraction Rate (\%)} = \{(\text{reduction in thickness by contraction}) / (\text{thickness before contraction})\} \times 100$$

Thickness before contraction = thickness of contracted portion (deep-colored portion in TEM cross-section) × 1.5 + thickness of non-contracted portion (light-colored portions in TEM cross-section)

Reduction in thickness by contraction= thickness of contracted portions (deep-colored TEM cross-section) × 0.5

It should be noted that the reduction in thickness by the contraction is synonymous with the thickness represented by (thickness of Sample A - thickness of Sample B), like the calculation of the contraction rate in Measurement 1.

In the present invention, a desired contraction rate can be provided by appropriately selecting a type of polysilazane, intensity of vacuum ultraviolet (VUV) beams having a wavelength of 200 nm or less, or irradiation time. The selection of the light intensity and irradiation time can stably control the concentration rate, and the selection of the irradiation time can more stably control the concentration rate.

In the present invention, the inorganic polymer layer is formed on the gas barrier layer through, for example, plasma-enhanced CVD in a discharge space of an applied magnetic field between rollers. The gas barrier film produced through such a process can exhibit high flatness after being kept in a high-temperature and high-humid environment. In addition, microscopic defects on the gas barrier layer formed during the forming process of the gas barrier layer can be filled with the polysilazane of the inorganic polymer layer applied on the gas barrier layer. The gas barrier film formed through such a process can effectively prevent gas purge and exhibit high gas barrier properties and flexibility.

The inorganic polymer layer should preferably have a thickness in a range of 50 to 500 nm, more preferably 50 to 300 nm. A gas barrier film including an inorganic polymer layer having a thickness of 50 nm or greater can exhibit desired flatness. A gas barrier film including an inorganic polymer layer having a thickness of 500 nm or less can exhibit desired flatness and prevent defects, such as cracks, on the gas barrier film or a dense silicon oxynitride film.

In the present invention, at least one inorganic polymer layer is formed which has a contraction rate in a range of 10 to 30%. Alternatively, two or more inorganic polymer layers or a lamination of the inorganic polymer layer according to the present invention and another functional layer may be formed, within a range to achieve the advantageous effects of the present invention.

(3.2) Polysilazane

The polysilazane according to the present invention is a polymer having a molecular structure of silicon-nitrogen bonds and is a precursor of silicon oxynitride. Any polysilazane may be used, and preferred is a compound having a structure represented by Formula (1):

[Formula 1]

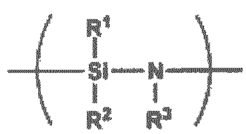

where $R^1$, $R^2$, and $R^3$ represent hydrogen atoms, alkyl groups, alkenyl groups, cycloalkyl groups, aryl groups, alkylsilyl groups, alkylamino groups, or alkoxy groups.

In the present invention, the polysilazane should preferably be perhydropolysilazane (PHPS), wherein $R^1$, $R^2$, and $R^3$ are hydrogen atoms, to provide a dense inorganic polymer layer.

The perhydropolysilazane is in the form of liquid or solid, and presumably has straight-chain structures and cyclic structures that are composed mainly of six-membered rings and eight-membered rings, and a number average molecular weight (Mn) of approximately 600 to 2000 (polystyrene equivalent value by gel permeation chromatography).

The polysilazane is commercially available in the form of solution in organic solvent. The commercially available polysilazane can be directly used as a polysilazane solution. Examples of a commercially available polysilazane solution include NN120-20, NAX120-20, and NL120-20, which are available from AZ Electronic Materials.

An inorganic polymer layer can be produced by applying the polysilazane solution to form a coating layer onto

the gas barrier layer, which is formed through, for example, plasma-enhanced CVD in a discharge space of an applied magnetic field between rollers, drying the coating layer, and modifying the coating layer with vacuum ultraviolet beams.

It is desirable that the polysilazane solution should contain any organic solvent other than alcohol solvent and aqueous solvent, which are readily reacted with the polysilazane. Examples of the usable organic solvent include hydrocarbon solvents, such as aliphatic hydrocarbons, alicyclic hydrocarbons, and aromatic hydrocarbons, halogenated hydrocarbon solvents, and ethers, such as aliphatic ethers and alicyclic ethers. Specific examples of the organic solvent includes carbon hydrides, such as pentane, hexane, cyclohexane, toluene, xylene, solvesso, and turpentine, halogenated hydrocarbons, such as methylene chloride and trichloroethane, and ethers, such as dibutyl ether, dioxane, and tetrahydrofuran. Appropriate organic solvent may be selected from these examples depending on purposes, such as the solubility of the polysilazane and the evaporation rate of the organic solvent. These organic solvents may be used in combination.

The concentration of the polysilazane in the coating solution for the formation of the inorganic polymer layer depends on the thickness of the inorganic polymer layer or the pot life of the solution, and should preferably be in a range of 0.2 to 35 mass%.

To accelerate denaturation into silicon oxynitride, amine catalysts or metal catalysts, such as Pt compounds, for example, Pt acetylacetonate, Pd compounds, for example, Pd propionate, and Rh compounds, for example, Rh acetylacetonate may be applied to the coating solution for the formation of an inorganic polymer layer. Particularly preferred are amine catalysts in the present invention. Specific examples of the amine catalysts include N,N-diethylethanolamine, N,N-dimethylethanolamine, triethanolamine, triethylamine, 3-morpholinopropylamine, N,N,N',N'-tetramethyl-1,3-diaminopropane, and N,N,N',N'-tetramethyl-1,6-diaminohexane.

The amount of the catalyst to the polysilazane should preferably be in a range of 0.1 to 10 mass% relative to the total mass of the coating solution for the formation of an inorganic polymer layer, more preferably 0.2 to 5 mass%, still more preferably 0.5 to 2 mass%. The polysilazane solution containing the catalyst within the range can prevent an excessive formation of silanol compounds, decrease in film density, and increase in film defect that are caused by a rapid reaction.

The polysilazane solution for the formation of the inorganic polymer layer may be applied by any appropriate wet application process. Specific examples of the wet application process include roller coating, flow coating, ink-jet coating, spray coating, print coating, dip coating, film casting, bar coating, and gravure printing.

A coating layer formed by applying the polysilazane solution may have any appropriate thickness depending on purposes. For example, the dried coating layer should preferably have a thickness in a range of 50 nm to 2 $\mu$m, more preferably 70 nm to 1.5 $\mu$m, still more preferably 100 nm to 1 $\mu$m.

(3.3) Irradiation Process with Vacuum Ultraviolet Beam

At least part of the polysilazane in the inorganic polymer layer according to the present invention is modified into silicon oxynitride by the irradiation with vacuum ultraviolet (VUV) beams.

<3.3.1> Modification with Vacuum Ultraviolet Irradiation

A plausible mechanism of the modification of the polysilazane coating layer into a specified composition or $SiO_xN_y$ during the irradiation process with the vacuum ultraviolet beams will now be described with reference to perhydropolysilazane as an example.

The perhydropolysilazane has a composition represented by $-(SiH_2-NH)_n-$. The perhydropolysilazane also can be represented by $SiO_xN_y$, wherein x=0 and y=1. To satisfy x>0, some external oxygen source is required. Examples of the oxygen source are shown as follows:

(i) Oxygen and water contained in the polysilazane solution
(ii) Oxygen and water in an atmosphere to be incorporated into the coating layer during the drying process
(iii) Oxygen, water, ozone, and singlet oxygen in an atmosphere to be incorporated into the coating layer during the irradiation process with vacuum ultraviolet beams
(iv) Oxygen and water to be transferred in the form of an outgas from the substrate into the coating layer by thermal energy generated in the irradiation process with vacuum ultraviolet beams
(v) When the irradiation process with vacuum ultraviolet beams is performed in an unoxidizing atmosphere, oxygen and water in an oxidizing atmosphere to be incorporated into the coating layer, after being shifted from the unoxidizing atmosphere to the oxidizing atmosphere

The upper limit of y is 1 because it is presumed that nitridation of Si requires very particular conditions compared to oxidation of Si.

The values of x and y basically lie in a range of $2x+3y \leq 4$ in association with atomic bonding of Si, O, and N.

After complete oxidation where y=0, the coating layer includes silanol groups, and the value of x may lie in a range of $2<x<2.5$.

A plausible reaction mechanism of the perhydropolysilazane which generates silicon oxynitride and silicon oxide during the irradiation process with vacuum ultraviolet beams will now be described.

(1) Dehydrogenation, and Formation of Si-N Bond Caused Thereby

It is presumed that Si-H bonds and N-H bonds in the perhydropolysilazane are relatively readily broken by excitation of the vacuum ultraviolet beams, and recombine into Si-N bonds in an inert atmosphere (sometimes dangling bonds of Si are generated) . In other words, these Si-H bonds and N-H bonds are linked into cured $SiN_y$ compositions without oxidation. Main chain links of the polymer are not broken. Breakage of Si-H bonds and N-H bonds are promoted by catalysts and heat. The hydrogen radicals H from these bonds are combined into a hydrogen molecule $H_2$, which are released to the exterior of the film.

(2) Formation of Si-O-Si Bond Caused by Hydrolysis and Dehydration Condensation

The Si-N bonds in the perhydropolysilazane are hydrolyzed by water, and the main chain links of polymers are then broken to form Si-OH bonds. Two Si-OH bonds are dehydrated and condensed to form Si-O-Si bonds, which are cured. Such reactions can also be caused in the air; however, during the irradiation with vacuum ultraviolet beams in an inert atmosphere, these reactions can be caused mainly by vapor or outgas from the resin substrate generated by heat of the irradiation. Excess moisture leads to residual Si-OH bonds that are not dehydrated and condensed, and thus the resulting cured film, which has the composition represented by $SiO_{2.1}$-$SiO_{2.3}$, exhibits low gas barrier properties.

(3)Direct Oxidation by Singlet Oxygen, and Formation of Si-O-Si Bonds

The irradiation with vacuum ultraviolet beams in an atmosphere containing a predetermined amount of oxygen forms singlet oxygen having significantly high oxidizability. The atoms of H or N in the perhydropolysilazane are replaced with O to form Si-O-Si bonds, which are then cured. It is presumed that breakage of main chain links of the polymers may cause recombination of chemical bonds.

(4) Oxidation Involving Breaking Si-N Bonds by Irradiation or Excitation with Vacuum Ultraviolet Beams

It is presumed that the Si-N bonds are broken by the energy of the vacuum ultraviolet beams, which is greater than the binding energy between Si and N in the perhydropolysilazane, and are oxidized into Si-O-Si and Si-O-N bonds in the presence of an oxygen source, for example, oxygen, ozone, or water in the environment. It is presumed that breakage of main chain links of the polymers may cause recombination of chemical bonds.

The formation of the silicon oxynitride compositions in the polysilazane layer by the irradiation with the vacuum ultraviolet beams can be conducted under the control of oxidation environment which is an appropriate combination of the oxidation mechanisms (1) to (4) described above.

In the irradiating process with the vacuum ultraviolet beams according to the present invention, the coating layer including polysilazane should preferably be irradiated with vacuum ultraviolet beams having an irradiance in a range of 30 to 200 $mW/cm^2$, more preferably 50 to 160 $mW/cm^2$. Irradiation with vacuum ultraviolet beams having an irradiance of 30 $mW/cm^2$ or greater is preferred because it has no risk to reduce modification efficiency. Irradiation with vacuum ultraviolet beams having an irradiance of 200 $mW/cm^2$ or less is preferred because it does not cause ablation of the coating layer and damages on the substrate.

The cumulative energy of the irradiation with the vacuum ultraviolet beams applied on the coating layer containing polysilazane should preferably be in a range of 200 to 10000 $mJ/cm^2$, more preferably 500 to 5000 $mJ/cm^2$. A cumulative energy of 200 $mJ/cm^2$ or greater can efficiently conduct the modification. A cumulative energy of 10000 $mJ/cm^2$ or less does not cause excess modification and can prevent cracking and thermal deformation of the resin substrate.

<3.3.2> Modifying Process with Excimer Light

A source of the vacuum ultraviolet beams should preferably be a rare gas excimer lamp. A rare gas is also referred to as an inert gas because the atoms of Xe, Kr, AR, and Ne do not chemically bond into molecules.

However, excited atoms in the rare gas which are energized by, for example, electric discharge can bond with other atoms into molecules. If the rare gas is xenon, $Xe_2^*$, which is an excited excimer atom, radiates excimer light beams having a wavelength of 172 nm when transitioning to a ground state. This reaction is represented by the following formulae:

$$e+Xe \rightarrow Xe^*$$

$$Xe^*+2Xe \rightarrow Xe_2^*+Xe$$

$$Xe_2^* \rightarrow Xe+Xe+hv\ (172nm)$$

An advantage of the excimer lamp lies in its high efficiency: the excimer lamp can emit light beams having the same wavelength substantially without unwanted light beams. Since the excimer lamp does not emit unwanted light beams, the excimer lamp can keep the target article at a low temperature. In addition, the excimer lamp can quickly flash because it takes little time to start and restart.

The excimer light beams are generated by a known method using dielectric barrier discharge. The dielectric barrier discharge is generated by applying a high frequency voltage of several ten kilohertz to a gas space between electrodes. A dielectric substance, such as transparent quartz, is disposed between the electrodes to provide the gas space. The dielectric barrier discharge is microscopic discharge like lightning, and is called microdischarge. Streamers of the microdischarge reach the surface of a tubular wall (or dielectric substance) to accumulate electric charge, which distinguishes the microdischarge.

The microdischarge propagates over the entire tubular wall and is repeatedly generated and extinguished. This causes flickering of light which can be visually observed. Furthermore, direct and regional irradiation of the tubular wall with the streamers at significantly high temperature may accelerate deterioration of the tubular wall.

The excimer light beams can be effectively generated by electrodeless field discharge, as well as dielectric barrier discharge. The electrodeless field discharge, which is caused by capacitive coupling, is also known as RF discharge. Although the lamp, electrodes, and configuration thereof for the electrodeless field discharge are basically the same as those for the dielectric barrier discharge, a radio frequency to be applied to a space between the electrodes has a bandwidth of several megahertz. The electrodeless field discharge, which can provide discharge stable over space and time, can achieve a long-life lamp without flickering.

In the dielectric barrier discharge, the microdischarge is generated only in the space between the electrodes. To cause the microdischarge in the entire discharge space, the outer electrode should cover the entire outer surface and should be composed of a light-transmissive material to transfer the light to the exterior.

Accordingly, a net of fine metal wire is used as an electrode. Such an electrode, which is composed of ultra-thin metal wire to transmit the light beams, is susceptible to damage caused by ozone in the vacuum ultraviolet beams in an oxygen atmosphere. To avoid the damage, the space surrounding the lamp or the interior of the irradiator needs to be purged with an inert gas, for example, nitrogen, and the irradiator needs to be provided with a synthetic silica window through which the irradiation light beams are transmitted. The synthetic silica window is an expensive consumable article and causes optical loss.

In a double-cylinder lamp having an outer diameter of approximately 25 mm, a noticeable difference is provided between the distance from the portion immediately below the lamp axis to an irradiated surface and the distance from the side of the lamp to an irradiated surface. This causes a considerable difference in illuminance between irradiated portions. Two lamps in close contact with each other thus cannot provide a uniform illuminance distribution. The irradiator having a synthetic silica window can provide a uniform distance to an irradiated surface in an oxygen atmosphere, and thus can provide a uniform illuminance distribution.

Electrodeless field discharge requires no net external electrode. Glow discharge can be spread over the entire discharge space only by placing the external electrode on part of the outer surface of the lamp. The external electrode is generally composed of an aluminum block, serves also as a light reflector, and is disposed on the back surface of the lamp. The lamp for the electrodeless field discharge has an outer diameter as large as that of for the dielectric barrier discharge, and is thus required to be provided with synthetic silica in order to provide uniform illuminance distribution.

A maximum advantage of a tubular excimer lamp lies in its simple structure, which has a tubular body containing a gas for generating excimer light beams and the gas is sealed inside by closing the edges of the silica tubes.

The tubular body of the tubular excimer lamp has an outer diameter of approximately 6 to 12 mm. A tubular body having a larger diameter needs higher voltage to start.

Either the dielectric barrier discharge or the electrodeless field discharge can be applied to the tubular excimer lamp. The electrode may have a flat surface in contact with the lamp. The electrode may have any surface profile conforming to the curved surface of the lamp. The electrode having such a profile can tightly fix the lamp. Such close contact of the electrode with the lamp leads to stable discharge. The electrode may have a curved mirror surface composed of aluminum, the mirror surface also serving as a light reflector.

A Xe excimer lamp, which emits ultraviolet beams having a single short wavelength of 172 nm, have high luminescent efficiency. The excimer light beams have a high oxygen absorption coefficient, and thus can generate high concentrations of radical oxygen atoms and ozone from a slight amount of oxygen.

The light beam having a short wavelength of 172 nm has energy that can dissociate the bonds of organic compounds with high efficiency. These radical oxygen, ozone, and high energy of the ultraviolet radiation can modify the polysilazane layer in a short time.

Compared to a low pressure mercury lamp having a wavelength of 185 nm or 254 nm and plasma cleaning, the Xe excimer lamp exhibits high throughput, which can achieve a short processing time, a decrease in an area for installation of facilities, and irradiation to organic materials and plastic substrates that are susceptible to thermal damage.

Excimer lamps exhibit high luminescent efficiency, and thus can emit light beams with low electric power. The excimer lamps do not emit light beams having a long wavelength, which lead to an increase in temperature, but radiate energy within an ultraviolet-light range, i.e., a short-wavelength range. This prevents an increase in temperature of the surface of the target article. The excimer lamps are suitable for the modification of materials including flexible films, such as PET, that are susceptible to thermal effects.

<3.3.3> Environment for Modification

Ultraviolet irradiation needs to be conducted in the presence of oxygen to cause chemical reactions. In contrast, vacuum ultraviolet irradiation is preferably conducted under a condition of extremely low oxygen concentration, because the efficiency of the ultraviolet irradiation process readily decreases due to absorption by oxygen. Specifically, the oxygen concentration during the vacuum ultraviolet irradiation should preferably be in a range of 10 to 10000 ppm, more preferably 50 to 5000 ppm, and still more preferably 1000 to 4500 ppm.

A dried inert gas is preferably used as gas satisfying conditions for the vacuum ultraviolet irradiation. A dried nitrogen gas is particularly preferred in view of costs. The oxygen concentration can be controlled by measuring the flow rates of an oxygen gas and an inert gas that are introduced in the irradiation environment, and altering the flow ratio between them.

[4] Other Functional Layers

The gas barrier film according to the present invention may include optional functional layers other than the layers described above.

<4.1> Overcoat Layer

The inorganic polymer layer according to the present invention may be covered with an overcoat layer for higher flexibility. Preferred examples of the material for the overcoat layer include organic resins, such as organic monomers, organic oligomers, and organic polymers, and organic-inorganic composite resins, such as siloxane having organic groups and monomer, oligomer, and polymer of silsesquioxane. These organic resins or organic-inorganic composite resins preferably have polymerizable groups or crosslinkable groups. The overcoat layer is preferably formed through a process which involves applying a solution including these organic resins or organic-inorganic composite resins and optional polymerization initiator or crosslinking agent to form a coating layer, and curing the coating layer through a light irradiation treatment or a thermal treatment.

<4.2> Anchor Layer

The gas barrier film according to the present invention may include an optional anchor layer (also referred to as clear hard coat (CHC) layer) between the resin substrate and the gas barrier layer, for higher adhesion between the resin substrate and the gas barrier layer.

The anchor layer can inhibit bleeding-out or a phenomenon where a surface of a resin substrate which is put into contact with another layer is contaminated by unreacted oligomers migrating from the interior of the resin substrate during a thermal treatment. The anchor layer should preferably have a flat surface for the lamination of the gas barrier layer thereon. The surface of the anchor layer should preferably have a roughness Ra in a range of 0.3 to 3 nm, more preferably 0.5 to 1.5 nm. An anchor layer having a roughness Ra of 0.3 nm or greater can exhibit appropriate flatness, and can maintain a desirable flatness for roller conveyance and the formation of the gas barrier layer through plasma-enhanced CVD. An anchor layer having a roughness of 3 nm or less can prevent microscopic defects on a gas barrier layer formed during the forming process of the gas barrier layer and allow the gas barrier layer to exhibit high gas barrier properties and high adhesion.

The anchor layer should preferably be composed of thermosetting resin or photosetting resin to achieve required flatness. Examples of the material for the anchor layer include epoxy resins, acrylic resins, urethane resins, polyester resins, silicone resins, and ethylene vinyl acetate (EVA). A resin composition composed of any of these materials described above can exhibit high light-transmittance. Among the groups of resin described above, preferred are photosetting and thermosetting resins. In particular, ultraviolet curable resins are preferred in view of its productivity and hardness, flatness, transparency of the resulting anchor layer.

Any resin that can be cured by ultraviolet beams and form a transparent composition may be used in the form of the ultraviolet curable resin. Particularly preferred are acrylic resins, urethane resins, and polyester resins in view of hardness, flatness, and transparency of the resulting conductive layer.

Examples of the acrylic resin composition include acrylate compounds having radically reactive unsaturated bonds, mercapto compounds including acrylate compounds and having thiol groups, solutions of multifunctional acrylate monomers, such as epoxy acrylate, urethane acrylate, polyester acrylate, polyether acrylate, polyethyleneglycol acrylate, and glycerol methacrylate. A mixture of two or more of these resin compositions may be used in a predetermined proportion. Any resin may be used that includes a reactive monomer that has at least one photopolymerizable unsaturated bond in a molecule.

Known photoinitiators may be used alone or in combination.

The anchor layer should preferably have a thickness in a range of 0.3 to 10 μm, more preferably 0.5 to 5 μm to control flatness.

<<Electronic Device>>

The gas barrier film according to the present invention is used in an electronic device.

Examples of the electronic device of the present invention include organic electroluminescent panels, organic electroluminescent devices, organic photoelectric convertors, and liquid crystal displays.

[1] Organic EL Panel as Electronic Device

A gas barrier film F according to the present invention having a structure illustrated in Fig. 1 can be used in the form of a sealing film to seal, for example, solar cells, liquid crystal displays, or organic EL devices.

Fig. 5 illustrates an exemplary organic EL panel P which is an electronic device including the gas barrier film F serving as a sealing film.

With reference to Fig. 5, the organic EL panel P includes the gas barrier film F, a transparent electrode 4 of, for example, ITO, formed on the gas barrier film F, an organic EL device 5, which is a body of the electronic device, formed on the gas barrier film F with the transparent electrode 4 in between, and a counter film 7, provided so as to cover the organic EL device 5 with an adhesive layer 6 in between. The transparent electrode 4 may be part of the organic EL device 5.

Specifically, the transparent electrode 4 and the organic EL device 5 are formed on the gas barrier film F on the surface on the side of the gas barrier layer 2 and an inorganic polymer layer 3.

The organic EL device 5 of the organic EL panel P is appropriately sealed not to be exposed to moisture vapor and is thus unlikely to be deteriorated. Such an organic EL panel P can be used for a long term. In other words, the organic EL panel P can have a longer service life.

The counter film 7 may be composed of a metal film, such as aluminum foil, or may be replaced with the gas barrier film according to the present invention. The gas barrier film functioning as the counter film 7 may be bonded with the adhesive layer 6 such that the gas barrier layer 2 faces the organic EL device 5.

[2] Organic EL Device

The organic EL device 5 sealed with the gas barrier film F in the organic EL panel P will now be described.

Although the following are specific examples of a preferred structure of the organic EL device 5, the list is not exhaustive:

(1) Positive Electrode / Luminescent Layer/ Negative Electrode
(2) Positive Electrode/ Hole Transport Layer/ Luminescent Layer/ Negative Electrode
(3) Positive Electrode/ Luminescent Layer/ Electron Transport Layer/ Negative Electrode
(4) Positive Electrode/ Hole Transport Layer/ Luminescent Layer/ Electron Transport Layer/ Negative Electrode
(5) Positive Electrode/ Positive Electrode Buffer Layer (Hole Injection Layer)/ Hole Transport Layer/ Luminescent Layer/ Electron Transport Layer/ Negative Electrode Buffer Layer (Electron Injection Layer) / Negative Electrode.

(2.1) Positive Electrode

Preferred examples of the material for the positive electrode (transparent electrode 4) of the organic EL device

5 include materials having a high work function (4 eV or greater), such as metals, alloys, electrically conductive compounds, and compositions including a mixture thereof. Specific examples of the electrode material include metals, such as Au, and transparent conductive materials, such as CuI, indium tin oxide (ITO), $SnO_2$, and ZnO. Alternatively, materials, such as IDIXO ($In_2O_3$-ZnO) may be used that can form an amorphous transparent conductive layer.

The positive electrode may be produced by depositing or sputtering any of these electrode materials into a film, and then patterning the film into a desired profile by a photolithographic process. Alternatively, the film may be patterned through a mask having a desired profile during the deposition or sputtering, if highly accurate patterning is not required (approximately 100 $\mu$m or greater).

The positive electrode should preferably have a light-transmittance of 10% or greater to transmit light beams. In addition, the positive electrode should preferably have a sheet resistance of several hundred $\Omega$/sq or less. The thickness of the positive electrode depends on the material of the positive electrode, and is generally selected within a range of 10 to 1000 nm, preferably 10 to 200 nm.

(2.2) Negative Electrode

Preferred examples of the material for the negative electrode of the organic EL device 5 include materials having a low work function (4 eV or less), such as metals (referred to as electron injection metals), alloys, electrically conductive compounds, and compositions including a mixture thereof. Specific examples of the electrode material include sodium, NaK alloys, magnesium, lithium, mixtures of magnesium and copper, mixtures of magnesium and silver, mixtures of magnesium and aluminum, mixtures of magnesium and indium, mixtures of aluminum and aluminum oxide ($Al_2O_3$), indium, mixtures of lithium and aluminum, and rare earth metals. Among them, appropriate electrode materials for the negative electrode are mixtures of an electron injection metal and a group 2 metal which has a higher and more stable work function than that of the electron injection metal, in view of their electron injection characteristics and resistance; for example, a mixture of magnesium and silver, a mixture of magnesium and aluminum, a mixture of magnesium and indium, a mixture of aluminum and aluminum oxide ($Al_2O_3$), a mixture of lithium and aluminum, and aluminum.

The negative electrode may be produced by depositing or sputtering any of these electrode materials into a film. The negative electrode should preferably have a sheet resistance of several hundred $\Omega$/sq or less. The thickness of the negative electrode is generally selected within a range of 10 nm to 5 $\mu$m, preferably 50 to 200 nm. Either the positive electrode or the negative electrode of the organic EL device 5 should advantageously be transparent or translucent to transmit irradiation light beams, in view of enhanced luminance.

A transparent or translucent negative electrode can be formed by laminating any of the transparent conductive materials, which are shown in the description of the positive electrode, on the metal film formed of any of the metals shown in the description of the negative electrode and having a thickness of 1 to 20 nm. Such a transparent or translucent negative electrode can be applied to a device having transparent positive electrode and negative electrode.

(2.3) Injection Layer

Injection layers are categorized into electron injection layers and hole injection layers. The electron injection layer and the hole injection layer may optionally be disposed between the positive electrode and the luminescent layer or the hole transport layer and between the negative electrode and the luminescent layer or the electron transport layer.

An injection layer is disposed between an electrode and an organic layer to decrease driving voltage and increase luminance. Details of the injection layer is disclosed in "Yuki EL Soshi to Sono Kogyoka Saizensen (Organic EL Devices and their Advanced Industrialization)", Second Edition, Chapter II "Denkyoku Zairyo (Electrode Material)" (pp. 123-166) (published by N.T.S. Co., Ltd., on November 30, 1998), which describes hole injection layers (positive electrode buffer layers) and electron injection layers (negative electrode buffer layers).

Detailed description of positive electrode buffer layers (hole injection layers) are also found in Japanese Unexamined Patent Application Publication Nos. H9-45479, H9-260062, and H8-288069. Specific examples include phthalocyanine buffer layers such as copper phthalocyanine, oxide buffer layers such as vanacium oxide, amorphous carbon buffer layers, and polymer buffer layers composed of conductive polymers, such as polyaniline (emeraldine) and polythiophene.

Detailed description of the negative electrode buffer layers (electron injection layers) are also found in Japanese Unexamined Patent Application Publication Nos. H.6-325871, H9-17574, and H10-74586. Specific examples include metal buffer layers such as strontium and aluminum, alkali metal compound buffer layers such as lithium fluoride, alkaline earth metal compound buffer layers such as magnesium fluoride, and oxide buffer layers such as aluminum oxide. The buffer (injection) layer should preferably be an ultra-thin film. The thickness of the buffer (injection) layer depends on the material thereof, and should preferably be 0.1 nm to 5 $\mu$m.

(2.4) Luminescent Layer

The luminescent layer in the organic EL device 5 emits light which is caused by recoupling of electrons and holes injected from the electrodes (negative and positive electrodes), the electron transport layer, or the hole transport layer. The luminescent layer may emit light at the interior of the luminescent layer or the interface between the luminescent layer and an adjacent layer.

The luminescent layer of the organic EL device 5 should preferably contain a luminescent dopant and a luminescent host that will be described below. This leads to higher luminescent efficiency.

<2.4.1> Luminescent Dopant

Luminescent dopants are generally categorized into two types, i.e., fluorescent dopants that generate fluorescence and phosphorescent dopants that generate phosphorescence.

Typical examples of the fluorescent dopant include coumarin pigments, pyran pigments, cyanine pigments, croconium pigments, squalium pigments, oxobenzanthracene pigments, fluorescein pigments, rhodamine pigments, pyrylium pigments, perylene pigments, stilbene pigments, polythiophene pigments, and rare-earth complex phosphors.

Typical examples of the phosphorescent dopant include complex compounds containing group 8, 9, and 10 metals of the periodic table of elements. Preferred are iridium compounds and osmium compounds, and mostly preferred are iridium compounds.

The luminescent dopant may be a mixture of compounds.

<2.4.2> Luminescent Host

A luminescent host (also simply referred to as host) refers to the most abundant compound (in mass ratio) in a luminescent layer composed of two or more compounds. The other compounds are referred to as "dopant compounds (also simply referred to as dopants) ". For example, in a luminous layer composed of two compounds, i.e., compounds A and B at a ratio of 10 : 90, compound A is a dopant compound and compound B is a host compound. In a luminous layer composed of three compounds, i.e., compounds A, B, and C at a ratio of 5:10:85, compounds A and B are dopant compounds, and compound C is a host compound.

The luminescent host may have any structure. Typical examples of the structure include a structure having a basic skeleton of carbazole derivatives, triarylamine derivatives, aromatic borane derivatives, nitrogen-containing heterocyclic compounds, thiophene derivatives, furan derivatives, or oligoarylene compounds, carboline derivatives, and diaza carbazole derivatives (in which at least one carbon atom of hydrocarbon rings constituting a carboline ring of a carboline derivative is replaced with a nitrogen atom). Among them, preferred are carboline derivatives and diaza carbazole derivatives.

<2.4.3> Formation of Luminescent Layer

The luminescent layer can be formed with any of the compounds described above through a known deposition process, for example, vacuum deposition, spin coating, casting, Langmuir Blodgett (LB) deposition, or ink-jetting. The luminescent layer may have any thickness, generally in a range of 5 nm to 5 $\mu$m, preferably 5 to 200 nm. The luminescent layer may have a monolithic structure composed of one or more dopant compounds and host compounds. Alternatively, the luminescent layer may have a laminate structure composed of a plurality of homogeneous or heterogeneous layers.

(2.5) Hole Transport Layer

Hole transport layers are composed of a material that can transport holes. In a broad sense, the hole transport layers include hole injection layers and electron blocking layers. One or more hole transport layers may be provided.

Materials for the hole transport layers have hole-injecting or hole-transporting characteristics or electron-barrier characteristics, and may be either organic materials or inorganic materials. Example of the materials include triazole derivatives, oxadiazole derivatives, imidazole derivatives, polyaryl alkane derivatives, pyrazoline derivatives, pyrazolone derivatives, henylenediamine derivatives, arylamine derivatives, amino-substituted chalcone derivatives, oxazole derivatives, styrylanthracene derivatives, fluorenone derivatives, hydrazine derivatives, stilbene derivatives, silazane derivatives, aniline copolymers, and conductive polymer oligomers, such as thiophene oligomers. These materials may be used as hole transport materials, and preferred are porphyrin compounds, aromatic tertiary amine compounds, and styrylamine compounds. Particularly preferred are aromatic tertiary amine compounds. Polymer materials including these hole transport materials in the polymer chains or polymer materials including these hole transport materials in the main chains may also be used. Inorganic compounds, such as p-type Si and p-type SiC, may also be used as hole

injection materials and hole transport materials.

The hole transport layer may be formed with any of the hole transporting materials described above through a known deposition process, for example, vacuum deposition, spin coating, casting, printing process including ink-jetting, or Langmuir Blodgett (LB) deposition. The hole transport layer may have any thickness, generally in a range of 5 nm to 5 μm, preferably 5 to 200 nm. The hole transport layer may have a monolithic structure composed of one or more materials selected from the materials described above.

(2.6) Electron Transport Layer

Electron transport layers are composed of a material that can transport electrons. In a broad sense, the electron transport layers include electron injection layers and hole blocking layers. One or more electron transport layers may be provided.

Any materials that can transport electrons injected from the negative electrode to the luminescent layer may be used for the electron transport layers. Any known chemical compound may be selected for the electron transport layers, for example, nitro-substituted fluorene derivatives, diphenylquinone derivatives, thiopyran dioxide derivatives, carbodiimide, fluorenylidene methane derivative, anthraquinodimethane and anthrone derivatives, and oxadiazole derivatives. The electron transport materials may be thiadiazole derivatives, which are the same as the oxadiazole derivatives except that the oxygen atoms of oxadiazole rings are replaced with sulfur atoms, and quinoxaline derivatives having quinoxaline rings, which are known as electron-withdrawing groups.

In addition, polymer materials including these electron transport materials in the polymer chains or polymer materials including these electron transport materials in the main chains may be used. Furthermore, the electron transport materials maybe metal complexes of 8-quinolinol derivatives, such as tris(8-quinolinol)aluminum (Alq), tris(5,7-dichloro-8-quinolinol)aluminum, tris(5,7-dibromo-8-quinolinol)aluminum, tris(2-methyl-8-quinolinol) aluminum, tris(5 -methyl-8-quinolinol)aluminum, and bis(8-quinolinol)zinc (Znq), and metal complexes which are the same as the metal complexes of 8-quinolinol derivatives except that they have central metals that are replaced with In, Mg, Cu, Ca, Sn, Ga, or Pb.

Examples of other preferred electron transport material include metal-free phthalocyanine and metal phthalocyanine, and metal-free phthalocyanine and metal phthalocyanine of which ends are replaced with alkyl groups or sulfonate groups. Inorganic semiconductors, such as n-type Si and n-type SiC, may be used as electron transport materials, as in the hole injection layers and hole transport layers.

The electron transport layer may be formed with any of the electron transporting materials described above through a known deposition process, for example, vacuum deposition, spin coating, casting, printing process including ink-jetting, or Langmuir Blodgett (LB) deposition. The electron transport layer may have any thickness, generally in a range of 5 nm to 5 μm, preferably 5 to 200 nm. The electron transport layer may have a monolithic structure composed of one or more materials selected from the materials described above.

(2.7) Production of Organic EL Device A method of producing an organic EL device will now be described.

Herein, a method of producing an exemplary organic EL device will now be described which includes a positive electrode, a hole injection layer, a hole transport layer, a luminescent layer, an electron transport layer, an electron injection layer, and a negative electrode.

A positive electrode composed of a desired electrode material, for example, positive electrode materials, and having a thickness of 1 μm or less, preferably in a range of 10 to 200 nm, is formed on a gas barrier film of the present invention through depositing, sputtering, or a plasma-enhanced CVD process, for example.

Functional layers of an organic EL device, i.e., a hole injection layer, a hole transport layer, a luminescent layer, an electron transport layer, and an electron injection layer are formed on the positive electrode through depositing or a wet process (spin coating, casting, ink-jetting, or printing), for example. Particularly preferred are vacuum deposition, spin coating, ink-jetting, and printing that can readily form uniform and substantially pinhole-free films. Alternatively, each functional layer may be formed by a different process. In the film-formation by deposition, the deposition conditions depend on types of compounds to be used; in general, appropriate conditions should preferably be determined within the following ranges: the boat heating temperature in a range of 50 to 450°C, the degree of vacuum in a range of $1\times10^{-6}$ to $1\times10^{-2}$ pa, the deposition rate in a range of 0.01 to 50 nm/sec, the temperature of the substrate in a range of -50 to 300°C, the thickness of the resulting film in a range of 0.1 nm to 5 μm, preferably 5 to 200 nm.

After the formation of these functional layers, a negative electrode composed of a negative electrode material and having a thickness of 1 μm or less, preferably in a range of 50 to 200 nm, is formed on the functional layers through deposition or sputtering, for example, to form a desired organic EL device.

In the formation of the organic EL device, the device including the positive electrode, the hole injection layer, and the negative electrode should preferably be formed through a single vacuum process. Alternatively, the device may be formed through a combination of the vacuum process and other film-forming processes. In this case, the organic EL

device should be formed in a dried inert gas atmosphere. The functional layers of the organic EL device may be formed in a reversed order, i.e., a negative electrode, an electron injection layer, an electron transport layer, a luminescent layer, a hole transport layer, a hole injection layer, and a positive electrode.

The electronic device (organic EL panel P) having the structure described above and including the gas barrier film according to the present invention can exhibit advantages inherent in the gas barrier film, such as high gas barrier properties and high flexibility. Additionally, the gas barrier film in such an electronic device can exhibit high flatness after being kept in high-temperature and high-humidity environments for a long period, which can maintain flatness of the entire organic EL panel. This can effectively prevent adverse effects caused by surface irregularity, such as separation of the film, deterioration caused by vibration, a decrease in flatness, and occurrence of dark-spots and can produce a high grade electronic device. Examples

The present invention will now be described in further detail with reference to non-limiting examples. Throughout the examples, the terms "part" and "%" respectively represent "part by mass" and "mass %" unless otherwise mentioned.

<<Production of Gas Barrier Film>>

[Production of Gas Barrier Film 1: Comparative Example]

(Preparation of Resin Substrate)

A resin substrate used was a biaxially stretched polyethylene naphthalate (PEN) film (thickness: 100 μm, width: 350 mm, Teonex Q65FA, available from Teijin DuPont Films Japan Limited).

(Formation of Anchor Layer)

A UV-curable organic/inorganic hybrid hard coat material, OPSTARZ7501, available from JSR Corporation, was applied with a wire bar to form a coating layer onto an easy adhesion surface of the resin substrate such that the dried coating layer had a thickness of 4 μm. The coating layer was dried at 80°C for 3 minutes. The dried coating layer was then cured into an anchor layer with a high-pressure mercury lamp under a condition of 1.0 J/$cm^2$ and in the air atmosphere.

(Formation of Gas Barrier Film: Roller CVD Process)

A plasma-enhanced CVD apparatus illustrated in Fig. 2 was used which includes film-forming rollers defining a discharge space to which a magnetic field is applied (hereinafter referred to as roller CVD method). The resin substrate having the anchor layer thereon was placed in the apparatus such that the opposite (rear) surface having no anchor layer thereon was in contact with the film-forming rollers. A gas barrier layer having a thickness of 300 nm was formed on the anchor layer under the following deposition (plasma-enhanced CVD) conditions.

<Conditions for Plasma-Enhanced CVD>

Feed amount of Material Gas (hexamethyldisiloxan (HMDSO)): 50 sccm (standard cubic centimeter per minute)
Feed amount of Oxygen Gas ($O_2$) : 500 sccm
Degree of Vacuum in Vacuum Chamber: 3 Pa
Electric Power from Plasma-Generating Power Source : 0.8 kW
Frequency of Plasma-Generating Power Source: 70 kHz
Transfer Rate of Resin Substrate: 2 m/min

<Measurement of Elemental Distribution Profile>

The resulting gas barrier layer was subjected to an XPS depth profile analysis to measure a silicon distribution curve, an oxygen distribution curve, a carbon distribution curve, and an oxygen-carbon distribution curve with respect to the distance from the surface of the film across the thickness.

Etching Ion: Argon ($Ar^+$)
Etching Rate (equivalent to $SiO_2$ thermal oxide film) : 0.05 nm/sec

Etching Interval (equivalent to $SiO_2$): 10 nm
X-ray photoelectron spectroscopic Apparatus: "VG Theta Probe" available from Thermo Fisher Scientific Inc.
X-ray Irradiation: Single Crystal Dispersed AlKα
Shape and Size of X-ray Spot: Ellipse of 800 × 400 μm

On the basis of the silicon, oxygen, carbon, and oxygen-carbon distribution curves of the entire gas barrier layer measured under the conditions described above, determined were the presence of a continuous changing region of each elemental content, the presence of extremum, a difference between the highest value of the carbon atom percentage and the lowest value of the carbon atom percentage, and average percentage of silicon, oxygen, and carbon atoms in a region of 90% or greater of the entire thickness.
Fig. 3 demonstrates the continuous changing region in composition and extrema were observed. The difference between the highest value of the carbon atom percentage and the lowest value of the carbon atom percentage was 16 at%. The average percentage of silicon, oxygen, and carbon atoms in a region of 90% or greater of the entire thickness had the correlation satisfying Inequality (A), i.e., (average carbon atom percentage) < (average silicon atom percentage) < (average oxygen atom percentage).

[Production of Gas Barrier Film 2 : Comparative Example]

(Preparation of Resin Substrate)

A resin substrate used was a biaxially stretched polyethylene naphthalate (PEN) film (thickness: 100 μm, width: 350 mm, Teonex Q65FA, available from Teijin DuPont Films Japan Limited).

(Formation of Anchor Layer)

A UV-curable organic/inorganic hybrid hard coat material, OPSTARZ7501, available from JSR Corporation, was applied with a wire bar to form a coating layer onto an easy adhesion surface of the resin substrate such that the dried coating layer had a thickness of 4 μm. The layer was dried at 80 °C for 3 minutes. The dried layer was then cured into an anchor layer with a high-pressure mercury lamp under a condition of 1.0 J/$cm^2$ and in the air atmosphere.

(Formation of Gas Barrier Layer: Vacuum Deposition)

A resistance heating boat carrying $SiO_2$ was energized and heated in a vacuum deposition apparatus to form a gas barrier layer composed of $SiO_2$ and having a thickness of 300 nm on the anchor layer at a deposition rate of 1 to 2 nm/sec.
The elemental distribution profiles of the resulting gas barrier layer were measured as described above. Fig. 4 demonstrates that no continuous changing region in composition or no extremum was observed, and the difference between the highest carbon percentage and the lowest carbon percentage was 1 at%. The average percentage of the silicon, oxygen, and carbon atoms in a range of 90% or greater of the entire thickness had the correlation satisfying Inequality (A).

(Formation of Inorganic Polymer Layer)

Glasca HPC7003 (corresponding to "Glasca" in Table 1), available from JSR Corporation, was applied to form a coating layer onto the gas barrier layer such that the dried coating layer had a thickness of 300 nm. The coating layer was dried at 120°C for 3 minutes into an inorganic polymer layer. The inorganic polymer layer corresponds to Gas barrier film 2. The inorganic polymer layer was not contracted (contraction rate: 0%).

[Production of Gas Barrier Film 3 : Comparative Example]

Gas barrier film 3 was produced as in the production of Gas barrier film 2, except that an inorganic polymer layer having a thickness of 300 nm was formed through the excimer treatment using polysilazane described below, in place of the forming process of the inorganic polymer layer described in the production of Gas barrier film 2.

(Excimer Treatment)

A gas barrier layer having a thickness of 300 nm was formed on the thin film layer by an excimer treatment.

<Preparation of Coating Solution for Forming Polysilazane Layer>

A coating solution used for forming a polysilazane layer was a solution (10 mass%) of perhydropolysilazane (AQUAMICA NN120-10, noncatalytic type, available from AZ Electronic Materials) in dibutyl ether.

<Formation of Polysilazane Layer>

The resulting coating solution for forming a polysilazane layer was applied with a wireless bar to form a coating layer such that the dried coating layer had a (average) thickness of 300 nm. The coating layer was dried in an atmosphere at a temperature of 85°C and a relative humidity of 55% for one minute, was left to stand in an atmosphere at a temperature of 25°C and a relative humidity of 10% (dew-point temperature -8°C) for 10 minutes, and was then dehumidified into a polysilazane layer.

<Formation of Inorganic Polymer Layer: Contraction of Polysilazane Layer with Vacuum Ultraviolet Light (Excimer Light) >

The resulting polysilazane layer was contracted into an inorganic polymer layer (with excimer light) in a vacuum chamber accommodating the following vacuum ultraviolet irradiator under a controlled pressure.

<Vacuum Ultraviolet Irradiator>

Device: Excimer UV lamp available from M.D.COM, Inc
MODEL: MECL-M-1-200 (Excimer Lamp)
UV Wavelength: 172 nm
Lamp Filler Gas: Xe
<Conditions for Contraction>

The resin substrate having the polysilazane layer thereon was fixed onto an operation stage and the polysilazane layer was contracted into an inorganic polymer layer under the following conditions.
Light Intensity of Excimer Lamp: 130 mW/cm$^2$ (172 nm)
Distance between Sample and Light Source: 1 mm
Heating Temperature of Stage: 70°C
Oxygen Concentration in Irradiator: 1.0%
Irradiation Time by Excimer Lamp: 5 seconds

<Measurement for Contraction Rate>

When the inorganic polymer layer was formed, the thickness of the polysilazane layer before the contraction and the thickness of the inorganic polymer layer formed by excimer irradiation were measured through Measurements 1 and 2 described below to determine a contraction rate. Each of the contraction rates measured through Measurements 1 and 2 was 15%.

[Production of Gas Barrier Film 4 : Comparative Example]

Gas barrier film 4 was produced by forming a gas barrier layer through a roller CVD as in the production of Gas barrier film 1, and forming an inorganic polymer layer (contraction rate 0%) through the same process as in the production of Gas barrier film 2, except that Glasca HPC7003, available from JSR Corporation, was used.

[Production of Gas Barrier Film 5 : Comparative Example]

Gas barrier film 5 was produced as in the production of Gas barrier film 4, except that an inorganic polymer layer was formed by the same excimer treatment as in the production of Gas barrier film 3. The irradiation time by the excimer lamp was changed to two seconds in the excimer treatment.
The contraction rate of the inorganic polymer layer of Gas barrier film 5 was 8%, which was measured by the processes described above.

[Production of Gas Barrier Film 6: Inventive Example]

Gas barrier film 6 was produced as in the production of Gas barrier film 4, except that an inorganic polymer layer was formed by the same excimer treatment as in the production of Gas barrier film 3.

The contraction rate of the inorganic polymer layer of Gas barrier film 6 was 15%, which was measured by the processes described above.

[Production of Gas Barrier Film 7: Inventive Example]

Gas barrier film 7 was produced as in the production of Gas barrier film 6, except that the irradiation with the excimer lamp was conducted for 16 seconds.

The contraction rate of the inorganic polymer layer of Gas barrier film 7 was 28%.

[Production of Gas Barrier Film 8 : Comparative Example]

Gas barrier film 8 was produced as in the production of Gas barrier film 6, except that the irradiation with the excimer lamp was conducted for 20 seconds.

The contraction rate of the inorganic polymer layer of Gas barrier film 7 was 35%.

[Production of Gas Barrier Film 9 : Comparative Example]

Gas barrier film 9 was produced as in the production of Gas barrier film 6, except that a gas barrier layer was formed through a roller CVD under conditions where the feed amount of material gas and oxygen gas and applied voltage were controlled such that the difference between the highest value and the lowest value of carbon atom was 4 at%.

[Production of Gas Barrier Film 10: Inventive Example]

Gas barrier film 10 was produced as in the production of Gas barrier film 6, except that a gas barrier layer was formed through a roller CVD under conditions where the feed amount of material gas and oxygen gas and applied voltage were controlled such that the difference between the highest value and the lowest value of carbon atoms was 7 at%.

[Production of Gas Barrier Film 11: Inventive Example]

Gas barrier film 11 was produced as in the production of Gas barrier film 6, except that a resin (PEN) substrate had a thickness of 50 μm, and that the irradiation with the excimer lamp was conducted for six seconds.

The contraction rate of the inorganic polymer layer of Gas Barrier film 11 was 16%.

[Production of Gas Barrier Film 12 : Inventive Example]

Gas barrier film 12 was produced as in the production of Gas barrier film 6, except that a resin (PEN) substrate had a thickness of 150 μm, and that the irradiation with the excimer lamp was conducted for seven seconds.

The contraction rate of the inorganic polymer layer of Gas barrier film 12 was 18%.

[Production of Gas Barrier Film 13 : Inventive Example]

Gas barrier film 13 was produced as in the production of Gas barrier film 6, except that a gas barrier layer had a thickness of 100 nm, and that the irradiation with the excimer lamp was conducted for eight seconds.

The contraction rate of the inorganic polymer layer of Gas barrier film 13 was 19%.

[Production of Gas Barrier Film 14 : Inventive Example]

Gas barrier film 14 was produced as in the production of Gas barrier film 6, except that a gas barrier layer had a thickness of 800 nm, and that the irradiation with the excimer lamp was conducted for nine seconds.

The contraction rate of the inorganic polymer layer of Gas barrier film 14 was 20%.

[Production of Gas Barrier Film 15: Inventive Example]

Gas barrier film 15 was produced as in the production of Gas barrier film 6, except that an inorganic polymer

layer had a thickness of 80 nm, and that the irradiation with the excimer lamp was conducted for 6.5 seconds.

The contraction rate of the inorganic polymer layer of Gas barrier film 14 was 17%.

[Production of Gas Barrier Film 16: Inventive Example]

Gas barrier film 16 was produced as in the production of Gas barrier film 6, except that an inorganic polymer layer had a thickness of 450 nm, and that the irradiation with the excimer lamp was conducted for 10 seconds.

The contraction rate of the inorganic polymer layer of Gas barrier film 16 was 21%.

[Production of Gas Barrier Film 17: Comparative Example]

Gas barrier film 17 was produced as in the production of Gas barrier film 6, except that a gas barrier layer and an inorganic polymer layer were formed in a reversed order, i.e. , in the sequence of a resin substrate, an anchor layer, an inorganic polymer layer, and a gas barrier layer.

[Production of Gas Barrier Film 18: Comparative Example]

(Preparation of Resin Substrate)

A resin substrate used as a biaxially stretched polyethylene naphthalate (PEN) film (thickness: 100 μm, width: 350 mm, Teonex Q65FA, available from Teijin DuPont Films Japan Limited).

(Formation of Anchor Layer)

A UV-curable organic/inorganic hybrid hard coat material, OPSTARZ7501, available from JSR Corporation, was applied with a wire bar to form a coating layer onto an easy adhesion surface of the resin substrate such that the dried coating layer had a thickness of 4 μm. The coating layer was then dried at 80°C for 3 minutes. The dried coating layer was then cured into an anchor layer with a high-pressure mercury lamp under a condition of 1.0 $J/cm^2$ and in the air atmosphere.

(Formation of Gas Barrier Layer: Plate Electrode CVD Apparatus)

A gas barrier layer having a thickness of 300 nm was deposited on the anchor layer in a commercially available plate electrode CVD apparatus under the following film-forming conditions (plasma-enhanced CVD conditions).

<Conditions for Plasma-Enhanced CVD>

Feed amount of Material Gas (hexamethyldisiloxan (HMDSO)): 20 sccm (Standard Cubic Centimeter per Minute)
Feed amount of Oxygen Gas ($O_2$) : 100 sccm
Degree of Vacuum in Vacuum Chamber: 10 Pa
Electric Power from Plasma-Generating Power Source: 0.5 kW
Frequency of Plasma-Generating Power Source: 13.56 MHz
Transfer Rate of Resin Substrate: 1 m/min

The elemental distribution profiles of the resulting gas barrier layer were measured as described above. Fig. 4 demonstrates that no continuously changing region in composition or no extremum was observed, and the difference between the highest value and the lowest value of the carbon atom percentage was 1 at%. The average percentage of the silicon, oxygen, and carbon atoms in a range of 90% or greater of the entire thickness had the correlation satisfying Inequality (A).

[Production of Gas Barrier Film 19: Comparative Example]

Gas barrier film 19 was produced as in the production of Gas barrier film 18, except that an inorganic polymer layer was formed on the gas barrier layer through the excimer treatment as in Gas barrier film 3.

[Production of Gas Barrier Film 20: Comparative Example]

Gas barrier film 20 was formed as in the production of Gas barrier film 6, except that the irradiation with an excimer lamp was conducted for 2.5 seconds to form an inorganic polymer layer.

[Production of Gas Barrier Film 21: Comparative Example]

Gas barrier film 21 was produced as in the production of Gas barrier film 6, except that the irradiation with an excimer lamp was conducted for eight seconds to form an inorganic polymer layer.

[Production of Gas Barrier Films 22 to 24: Inventive Examples]

Gas barrier films 22 to 24 were produced as in the production of Gas barrier film 6, except that each of the resin (PEN) substrates had a thickness shown in Table 1.

[Measurement of Contraction Rate of Inorganic Polymer Layer]

The contraction rate of the inorganic polymer layers of Gas barrier films 3, 5 to 16, and 19 to 24 was measured in accordance with Measurements 1 and 2 as follows.

Between Measurements 1 and 2 described below, the experimental error of the contraction rate of the inorganic polymer layer of each gas barrier film was 1% or less. Table 1 shows the contraction rates of the inorganic polymer layers measured by Measurement 1, as typical examples.

[Measurement 1]

The thickness of the polysilazane layer before the contraction and the thickness of the inorganic polymer layer after the contraction were measured by Measurement 1 as follows.

<Cross-Sectional TEM Observation>

The sample to be observed was processed into sample pieces with an FIB apparatus described below, and the sample pieces were subjected to TEM observation.

<FIB Treatment>

Device: SMI2050 available from SII
Ion for Processing: (Ga 30kV)
Thickness of Sample Piece: 200 nm

<TEM Observation>

Device: JEM2000FX (Accelerating Voltage: 200 kV) available from JEOL Ltd.
Electron Beam Irradiation Time: 30 seconds

The contraction rate was measured through the following processes.

$$\text{Contraction Rate (\%)} = [\{(\text{thickness of polysilazane layer before contraction}) - (\text{thickness of inorganic polymer layer after contraction})\} / (\text{thickness of polysilazane layer before contraction})] \times 100 (\%)$$

[Measurement 2]

The contraction rate of the inorganic polymer layer of Gas barrier film 2 after the contraction was measured in accordance with Measurement 2 as follows.

The contracted inorganic polymer layer was subjected to the TEM observation as in Measurement 1 described above. The cross-sectional image of the inorganic polymer layer observed through the TEM observation showed contracted portions in a deep color and non-contracted portions in a light color. The thickness of the deep-colored (contracted) portions and the thickness of the light-colored (non-contracted) portions were measured to determine the contraction rates (%) of these portions in accordance with the following expressions.

$$\text{Contraction rate (\%)} = \{(\text{reduction in thickness by contraction}) / (\text{thickness before contraction})\} \times 100$$

$$\text{Thickness before contraction} = \{\text{thickness of contracted portion (deep-colored portion in TEM cross-section)}\} \times 1.5 + \{\text{thickness of non-contracted portion (light-colored portions in TEM cross-section)}\}$$

$$\text{reduction in thickness by contraction} = \{\text{thickness of contracted portions (deep-colored TEM cross-section)}\} \times 0.5$$

It should be noted that the reduction in thickness by the contraction is equal to the thickness represented by (thickness of Sample A - thickness of Sample B), which was determined for the calculation of the contraction rate in Measurement 1.

[Table 1]

| GAS BARRIER FILM NUMBER | RESIN SUBSTRATE | | GAS BARRIER LAYER | | | | | | INORGANIC POLYMER LAYER | | | | REMARKS |
|---|---|---|---|---|---|---|---|---|---|---|---|---|---|
| | | | | | ATOM DISTRIBUTION PROFILE | | | | | | | | |
| | TYPE | THICKNESS ($\mu$m) | TYPE OF DEPOSITION | THICKNESS (nm) | FILM COMPOSITION CONTINUOUS CHANGE | EXTREMA | *1 (at%) | INEQUALITY (A) | MATERIAL | THICKNESS (nm) | TYPE OF PROCESSING | CONTRACTION RATE (%) | |
| 1 | PEN | 100 | ROLLER CVD | 300 | OBSERVED | OBSERVED | 16 | SATISFIED | - | - | - | - | COMPARATIVE |
| 2 | PEN | 100 | VACUUM DEPOSITION | 300 | NOT OBSERVED | NOT OBSERVED | 1 | SATISFIED | GLASCA | 300 | - | 0 | COMPARATIVE |
| 3 | PEN | 100 | VACUUM DEPOSITION | 300 | NOT OBSERVED | NOT OBSERVED | 1 | SATISFIED | POLYSILAZANE | 300 | EXCIMER TREATMENT | 15 | COMPARATIVE |
| 4 | PEN | 100 | ROLLER CVD | 300 | OBSERVED | OBSERVED | 16 | SATISFIED | GLASCA | 300 | - | 0 | COMPARATIVE |
| 5 | PEN | 100 | ROLLER CVD | 300 | OBSERVED | OBSERVED | 16 | SATISFIED | POLYSILAZANE | 300 | EXCIMER TREATMENT | 8 | COMPARATIVE |
| 6 | PEN | 100 | ROLLER CVD | 300 | OBSERVED | OBSERVED | 16 | SATISFIED | POLYSILAZANE | 300 | EXCIMER TREATMENT | 15 | INVENTIVE |
| 7 | PEN | 100 | ROLLER CVD | 300 | OBSERVED | OBSERVED | 16 | SATISFIED | POLYSILAZANE | 300 | EXCINER TREATMENT | 28 | INVENTIVE |
| 8 | PEN | 100 | ROLLER CVD | 300 | OBSERVED | OBSERVED | 16 | SATISFIED | POLYSILAZANE | 300 | EXCINER TREATMENT | 35 | COMPARATIVE |
| 9 | PEN | 100 | ROLLER CVD | 300 | OBSERVED | OBSERVED | 4 | SATISFIED | POLYSILAZANE | 300 | EXCIMER TREATMENT | 15 | COMPARATIVE |

(continued)

| GAS BARRIER FILM NUMBER | RESIN SUBSTRATE | | GAS BARRIER LAYER | | | | | | INORGANIC POLYMER LAYER | | | | REMARKS |
|---|---|---|---|---|---|---|---|---|---|---|---|---|---|
| | | | | | ATOM DISTRIBUTION PROFILE | | | | | | | | |
| | TYPE | THICKNESS ($\mu m$) | TYPE OF DEPOSITION | THICKNESS (nm) | FILM COMPOSITION CONTINUOUS CHANGE | EXTREMA | *1 (at%) | INEQUALITY (A) | MATERIAL | THICKNESS (nm) | TYPE OF PROCESSING | CONTRACTION RATE (%) | |
| 10 | PEN | 100 | ROLLER CVD | 300 | OBSERVED | OBSERVED | 7 | SATISFIED | POLYSILAZANE | 300 | EXCIMER TREATMENT | 15 | INVENTIVE |
| 11 | PEN | 50 | ROLLER CVD | 300 | OBSERVED | OBSERVED | 16 | SATISFIED | POLYSILAZANE | 300 | EXCIMER TREATMENT | 16 | INVENTIVE |
| 12 | PEN | 200 | ROLLER CVD | 300 | OBSERVED | OBSERVED | 16 | SATISFIED | POLYSILAZANE | 300 | EXCIMER TREATMENT | 18 | INVENTIVE |
| 13 | PEN | 100 | ROLLER CVD | 100 | OBSERVED | OBSERVED | 16 | SATISFIED | POLYSILAZANE | 300 | EXCIMER TREATMENT | 19 | INVENTIVE |
| 14 | PEN | 100 | ROLLER CVD | 800 | OBSERVED | OBSERVED | 16 | SATISFIED | POLYSILAZANE | 300 | EXCIMER TREATMENT | 20 | INVENTIVE |
| 15 | PEN | 100 | ROLLER CVD | 300 | OBSERVED | OBSERVED | 16 | SATISFIED | POLYSILAZANE | 80 | EXCIMER TREATMENT | 17 | INVENTIVE |
| 16 | PEN | 100 | ROLLER CVD | 300 | OBSERVED | OBSERVED | 16 | SATISFIED | POLYSILAZANE | 450 | EXCIMER TREATMENT | 21 | INVENTIVE |
| 17 | SAME AS IN GAS BARRIER FILM 6 EXCEPT A GAS BARRIER LAYER AND AN INORGANIC POLYMER LAYER DEPOSITED IN THE REVERSED ORDER | | | | | | | | | | | | COMPARATIVE |

(continued)

| GAS BARRIER FILM NUMBER | RESIN SUBSTRATE | | GAS BARRIER LAYER | | | | | | INORGANIC POLYMER LAYER | | | | REMARKS |
|---|---|---|---|---|---|---|---|---|---|---|---|---|---|
| | | | | | ATOM DISTRIBUTION PROFILE | | | | | | | | |
| | TYPE | THICKNESS (μm) | TYPE OF DEPOSITION | THICKNESS (nm) | FILM COMPOSITION CONTINUOUS CHANGE | EXTREMA | *1 (at%) | INEQUALITY (A) | MATERIAL | THICKNESS (nm) | TYPE OF PROCESSING | CONTRACTION RATE (%) | |
| 18 | PEN | 100 | PLATE CVD | 300 | NOT OBSERVED | NOT OBSERVED | 1 | SATISFIED | - | - | - | - | COMPARATIVE |
| 19 | PEN | 100 | PLATE CVD | 300 | NOT OBSERVED | NOT OBSERVED | 1 | SATISFIED | POLYSILAZANE | 300 | EXCIMER TREATMENT | 15 | COMPARATIVE |
| 20 | PEN | 100 | ROLLER CVD | 300 | OBSERVED | OBSERVED | 16 | SATISFIED | POLYSILAZANE | 300 | EXCIMER TREATMENT | 10 | INVENTIVE |
| 21 | PEN | 100 | ROLLER CVD | 300 | OBSERVED | OBSERVED | 16 | SATISFIED | POLYSILAZANE | 300 | EXCIMER TREATMENT | 20 | INVENTIVE |
| 22 | PEN | 12 | ROLLER CVD | 300 | OBSERVED | OBSERVED | 16 | SATISFIED | POLYSILAZANE | 300 | EXCIMER TREATMENT | 15 | INVENTIVE |
| 23 | PEN | 15 | ROLLER CVD | 300 | OBSERVED | OBSERVED | 16 | SATISFIED | POLYSILAZANE | 300 | EXCIMER TREATMENT | 15 | INVENTIVE |
| 24 | PEN | 100 | ROLLER CVD | 300 | OBSERVED | OBSERVED | 16 | SATISFIED | POLYSILAZANE | 300 | EXCIMER TREATMENT | 15 | INVENTIVE |

*1: HIGHEST VALUE OF CARBON ATOM - LOWEST VALUE OF CARBON ATOM (at%)

<<Electronic Device: Production od Organic El Panel>>

[Production od Organic El Panel]

Formation of First Electrode Layer

An indium tin oxide (ITO) layer having a thickness of 150 nm was formed on the gas barrier layer of Gas barrier film 1 by sputtering, and was patterned into a first electrode layer by a photolithographic process. The patterned first electrode had an emission area of 50 mm square.

(Formation of Hole Transport Layer)

A coating solution for forming a hole transport layer, which will be described below, was applied onto the first electrode layer of Gas barrier film 1 with an extrusion coater in an environment of 25°C and RH of 50%, and was dried and thermally processed into a hole transport layer under the conditions described below. The coating solution for forming a hole transport layer was applied such that the dried hole transport layer had a thickness of 50 nm.

Before the application of the coating solution for forming a hole transport layer, two surfaces of Gas barrier film 1 were cleaned and modified using a low pressure mercury lamp having a wavelength of 184.9 nm, at an irradiation intensity of 15 $mW/cm^2$ and a distance of 10 mm. Static charges on the surfaces were removed by weak X-rays from a destaticizer.

<Preparation of Coating Solution for Forming Hole Transport Layer>

Polyethylenedioxythiophene polystyrene sulfonate (PEDOT/PSS, Bytron P AI 4083 available from Bayer AG) diluted in deionized water (65%) and methanol (5%) was used as a coating solution for forming a hole transport layer.

<Conditions for Drying and Thermal Processing>

After the application of the coating solution for forming a hole transport layer on the first electrode, the resulting coating layer was dried with hot air (height: 100 mm, discharge velocity: 1 m/s, wind speed distribution in width direction: 5%, temperature: 100°C) to remove the solvent, and was subjected to a backside heat transferring thermal process using a heater at a temperature of 150°C to form a hole transport layer.

(Formation of Luminescent Layer)

After the application of a coating solution for forming a white-luminescent layer described below on the hole transport layer with an extrusion coater under the conditions described below, the resulting coating layer was then dried and thermally processed into a luminescent layer. The coating solution for forming a white-luminescent layer was applied such that the dried luminescent layer had a thickness of 40 nm.

<Preparation of Coating Solution for Forming White-Luminescent Layer>

The compound H-A (1.0g) as a host material, the compound D-A (100 mg) as a first dopant material, the compound D-B (0.2 mg) as a second dopant material, and the compound D-C (0.2 mg) as a third dopant material were diluted in toluene (100 g) to prepare a coating solution for forming a white-luminescent layer.

[Formula 2]

H-A

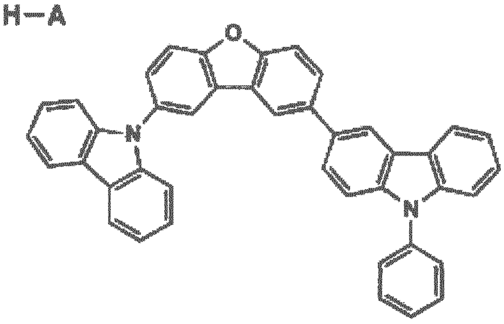

D-A

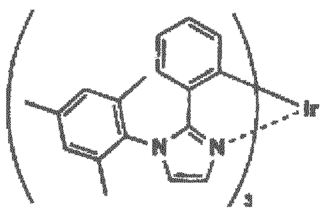

D-B

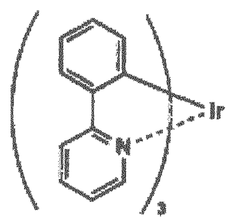

D-C

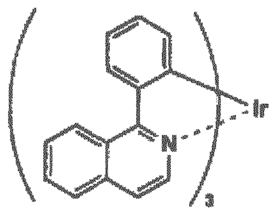

<Conditions for Coating>

The coating solution for forming a white-luminescent layer was applied in an atmosphere with a nitrogen gas concentration of 99% or greater by volume, at a temperature of 25°C, and at a coating rate of 1 m/min.

<Conditions for Drying and Thermal Processing>

After the application of the coating solution for forming a white-luminescent layer on the hole transport layer, the resulting coating layer was dried with hot air (height: 100 mm, discharge velocity: 1 m/s, wind speed distribution in width direction: 5%, temperature: 60°C) to remove the solvent, and was subjected to a thermal process at a temperature of 130°C to form a luminescent layer.

(Formation of Electron Transport Layer)

After the application of a coating solution for forming an electron transport layer described below on the luminescent layer with an extrusion coater under the conditions described below, the resulting coating layer was dried and thermally processed into an electron transport layer. The solution for forming an electron transport layer was applied such that the dried electron transport layer had a thickness of 30 nm.

<Preparation of Coating Solution for Forming Electron Transport Layer>

The compound E-A (0.5 mass%) was diluted in 2,2,3,3-tetrafluoro-1-propanol to prepare a solution for forming an electron transport layer.

[Formula 3]

E-A

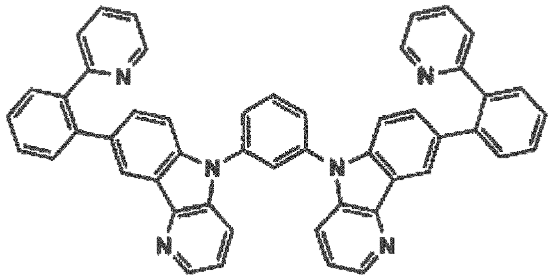

<Conditions for Coating>

The coating solution for forming an electron transport layer was applied in a nitrogen atmosphere containing 99% or greater by volume of nitrogen gas, at a temperature of 25°C, and at a coating rate of 1 m/min.

<Conditions for Drying and Thermal Processing>

After the application of the coating solution for forming an electron transport layer on the luminescent layer, the resulting coating layer was dried with hot air (height: 100 mm, discharge velocity: 1 m/s, wind speed distribution in width direction: 5%, temperature: 60°C) to remove the solvent, and was subjected to a thermal process using a heating unit at a temperature of 200°C to form an electron transport layer.

(Formation of Electron Injection Layer)

An electron injection layer was formed on the electron transport layer in accordance with the following processes.

The workpiece which is to be the gas barrier film 1 with the layer up to the electron transport layer formed was disposed in a chamber, and the chamber was then decompressed to $5\times10^{-4}$ Pa. A tantalum evaporation boat disposed in the chamber and preliminarily loaded with cesium fluoride was heated to form an electron injection layer having a thickness of 3 nm on the electron transport layer.

(Formation of Second Electrode)

The electron injection layer was masked in a portion of the first electrode excluding the portion which is to be an extraction electrode and aluminum was deposited thereon in a vacuum atmosphere of $5\times10^{-4}$ Pa to form an aluminum second electrode with the extraction electrode. The second electrode has a thickness of 100 nm. The resulting laminate had 50-mm square emitting regions.

(Cutting)

The laminate was cut into an organic EL device 1 having a predetermined dimension with an ultraviolet laser in a nitrogen atmosphere.

(Lead-Wire Connection of Electrode)

The organic EL device 1 was connected to a flexible printed board (which was composed of a base film formed of polyimide and having a thickness of 12.5 μm, a rolled copper sheet having a thickness of 18 μm, and a cover lay formed of polyimide and having a thickness of 12.5μm, and was surface-treated with NiAu plating) via an anisotropic conductive film DP3232S9 available from Sony Chemical & Information Device Corporation.

The organic EL device 1, the anisotropic conductive film, and the flexible printed board were bonded under the conditions at a temperature of 170°C (ACF temperature: 140°C measured with a thermocouple) and a pressure of 2 MPa for 10 seconds.

(Sealing)

A sealant prepared was a laminate composed of, in sequence, a poly(ethylene terephthalate) (PET) film having a thickness of 12 μm, a dry lamination adhesive (two-part reactive urethane adhesive) layer having a thickness of 1.5 μm, and an aluminum sheet having a thickness of 30 μm (available from Toyo Aluminum K.K.).
A thermosetting adhesive was uniformly applied over the aluminum surface (polished surface) of the sealant with a dispenser to form an adhesive layer having a thickness of 20 μm.
The thermosetting adhesive used was an epoxy adhesive which was the mixture of the following components (A), (B), and (C):
(A) Bisphenol A diglycidyl ether (DGEBA),
(B) Dicyandiamide (DICY), and
(C) Epoxy adduct curing agent.

The sealant was put into close contact with the organic EL device 1 so as to cover the extraction electrode and the junctions of the electrode leads, and the sealant and the organic EL device 1 were tightly bonded with pressure rollers, under a pressure of 0.5 MPa, at a temperature of 120°C, and a transfer rate of 0.3 m/min to form an organic EL panel 1 illustrated in Fig. 5.

[Production of Organic EL Panels 2 to 24]

Organic EL panels 2 to 24 were produced as in the production of Organic EL panel 1, except that Gas barrier film 1 was replaced with Gas barrier films 2 to 24.

<<Evaluation of Organic EL Panels>>

These organic EL panels were evaluated for a moisture vapor permeation rate and durability (flatness) in accordance with the following processes.

[Measurement of Moisture Vapor Permeation Rate]

The results of the measurement in accordance with JIS K 7129-1992 showed that each organic EL panel had a moisture vapor permeation rate of $3\times10^{-3}$ g/ ($m^2$·24h) or less (temperature: 60±0.5°C, RH: 90±2%).

[Evaluation of Durability]

The organic EL panels were subject to an accelerated deterioration test in an environment at a temperature of 60°C and a relative humidity of 90% for 400 hours to evaluate the flatness and dark-spot resistance of these panels as follows.

(Evaluation of Flatness)

Surface irregularity of the emitting surfaces of the organic EL panels after the accelerated deterioration test was measured through the process described below to evaluate the flatness of the organic EL panels in accordance with the following criteria. The criteria Excellent and Good indicate practically allowable flatness.

<Measurement of Surface Irregularity>

The surface irregularity of the organic EL panels was measured with a CNC vision measuring device, Quick Vision QVH404 (available from Mitutoyo Corporation).

<Evaluation Criteria>

Excellent: Surface irregularity < 0.05 mm
Good: 0.05 mm ≤ Surface irregularity < 0.10 mm

Fair: 0.10 mm ≤ Surface irregularity < 1.0 mm
Poor: 1.0 mm ≤ Surface irregularity

(Evaluation of Dark-spot Resistance)

The organic EL panels after the accelerated deterioration test were each driven at an applied current of 1 mA/cm$^2$ continuously for 24 hours. A certain region of the driven organic EL panel was photographed at a magnification of 100 times with an optical microscope (MS-804, lens: MP-ZE25-200, available from Moritex Corporation) to observe the emission of the organic EL panel. Dark-spots were observed in a 2-mm square section trimmed from the photographic image. The percentage of the area of the dark-spot regions to the emission area was determined to evaluate the dark-spot resistance (simply referred to as DS resistance) in accordance with the following criteria. The criteria Excellent and Good indicate practically allowable DS resistance.
Excellent: No dark-spot observed
Good: Slight dark-spots observed (0.1% ≤ Area Rate < 1.5%)
Fair: Minor dark-spots observed (1.5% ≤ Area Rate < 3.0%)
Poor: Distinct dark-spots observed (3.0% ≤ Area Rate)

The results of the measurement are shown in Table 2.

[Table 2]

| ORGANIC EL PANEL NUMBER | GAS BARRIER FILM NUMBER | EVALUATION OF DURABILITY | | REMARKS |
|---|---|---|---|---|
| | | FLATNESS | DARK SPOT RESISTANCE | |
| 1 | 1 | FAIR | FAIR | COMPARATIVE |
| 2 | 2 | FAIR | FAIR | COMPARATIVE |
| 3 | 3 | POOR | POOR | COMPARATIVE |
| 4 | 4 | FAIR | FAIR | COMPARATIVE |
| 5 | 5 | FAIR | FAIR | COMPARATIVE |
| 6 | 6 | EXCELLENT | EXCELLENT | INVENTIVE |
| 7 | 7 | GOOD | EXCELLENT | INVENTIVE |
| 8 | 8 | FAIR | FAIR | COMPARATIVE |
| 9 | 9 | FAIR | FAIR | COMPARATIVE |
| 10 | 10 | EXCELLENT | EXCELLENT | INVENTIVE |
| 11 | 11 | EXCELLENT | EXCELLENT | INVENTIVE |
| 12 | 12 | GOOD | GOOD | INVENTIVE |
| 13 | 13 | EXCELLENT | EXCELLENT | INVENTIVE |
| 14 | 14 | EXCELLENT | EXCELLENT | INVENTIVE |
| 15 | 15 | EXCELLENT | EXCELLENT | INVENTIVE |
| 16 | 16 | GOOD | GOOD | INVENTIVE |
| 17 | 17 | FAIR | FAIR | COMPARATIVE |
| 18 | 18 | FAIR | FAIR | COMPARATIVE |
| 19 | 19 | POOR | POOR | COMPARATIVE |
| 20 | 20 | GOOD | GOOD | INVENTIVE |
| 21 | 21 | EXCELLENT | EXCELLENT | INVENTIVE |
| 22 | 22 | GOOD | GOOD | INVENTIVE |

(continued)

| ORGANIC EL PANEL NUMBER | GAS BARRIER FILM NUMBER | EVALUATION OF DURABILITY | | REMARKS |
|---|---|---|---|---|
| | | FLATNESS | DARK SPOT RESISTANCE | |
| 23 | 23 | EXCELLENT | EXCELLENT | INVENTIVE |
| 24 | 24 | EXCELLENT | EXCELLENT | INVENTIVE |

Table 2 demonstrates that the organic EL panels including the gas barrier films having a configuration disclosed in the present invention exhibit high flatness, reduced stress on the luminescent layer due to the flatness retention, and high dark-spot resistance, even after the accelerated deterioration test in an environment at a temperature of 60°C and a relative humidity of 90% for a long term, compared to the comparative examples.

Additional advantages of the present invention will now be described in detail.

The gas barrier film of the present invention is characterized in that 1) the gas barrier film includes, in sequence, a resin substrate, a gas barrier layer, and an inorganic polymer layer; 2) the gas barrier layer has continuously changing composition across the thickness and satisfies Requirements (1) and (2) ; 3) the inorganic polymer layer is formed by contracting a polysilazane layer into a contraction rate in a range of 10 to 30%. Only a gas barrier film satisfying all the requirements can achieve advantageous effects of the present invention, i.e., high flatness and high dark-spot resistance after the accelerated deterioration test in a high-temperature and high-humidity environment, as well as high gas barrier properties.

In detail, Gas barrier film 1, which includes no inorganic polymer layer, exhibits low flatness and low dark-spot resistance after the accelerated deterioration test, compared to inventive Gas barrier film 6. Gas barrier film 18, which does not include an inorganic polymer layer and includes a gas barrier layer having a homogeneous elemental profile without extrema, exhibits low flatness and low dark-spot resistance after the accelerated deterioration test, compared to inventive Gas barrier film 6. Gas barrier films 2, 3, and 19 which have gas barrier layers with no continuously changing composition across the thickness but have a homogeneous profile without extrema also exhibit low flatness and low dark-spot resistance after the accelerated deterioration test.

A gas barrier film including a gas barrier film showing a difference of 5 at% or less between the highest value and the lowest value of carbon atom percentage exhibits low flatness and low dark-spot resistance after the accelerated deterioration test.

Gas barrier film 4 exhibits low flatness and low dark-spot resistance due to the imbalance in stress between these layers, which includes as an inorganic polymer layer composed of non-contractile Glasca and a gas barrier layer satisfying the requirements described herein.

It is found that the inventive gas barrier films each including an inorganic polymer layer showing a contraction rate in a range of 10 to 30% exhibit high flatness and high dark-spot resistance after comparison among Gas barrier films 5 to 8, 20 and 21. Among them, Gas barrier films 6 and 21, including an inorganic polymer layer which show a contraction rate in a range of 15 to 20%, exhibit particularly preferred properties.

It is found that a gas barrier film including a resin substrate having a thickness in a range of 15 to 150 $\mu$m can exhibit preferred properties after comparison among Gas barrier film 6 (including a 100-$\mu$m resin substrate), Gas barrier film 11 (including a 50-$\mu$m resin substrate), Gas barrier film 12 (including a 200-$\mu$m resin substrate), Gas barrier film 22 (including a 12-$\mu$m resin substrate), Gas barrier film 23 (including a 15-$\mu$m resin substrate), and Gas barrier film 2 (including a 150-$\mu$m resin substrate).

It is found that a gas barrier films including an inorganic polymer layer and gas barrier layer disposed on the inorganic polymer layer cannot provide the advantageous effects of the present invention after comparison of properties between Gas barrier film 6 and Gas barrier film 17.

Industrial Applicability

The gas barrier film according to the present invention can preferably be applied to electronic devices of the present invention, such as organic electroluminescent panels, organic electroluminescent devices, organic photoelectric conversion devices, and liquid crystal displays.

Reference Numeral List

| | |
|---|---|
| 1 | resin substrate |
| 2 | gas barrier layer |
| 3 | inorganic polymer layer |
| 4 | positive electrode (transparent electrode) |
| 5 | organic EL device (body of the electronic device) |
| 6 | adhesive layer |
| 7 | counter film |
| F | gas barrier film |
| P | organic EL panel (electronic device) |
| 11 | delivering roller |
| 21, 22, 23, 24 | transferring roller |
| 31, 32 | film-forming roller |
| 41 | gas feeder |
| 51 | plasma-generating power source |
| 61, 62 | magnetic-field generating device |
| 71 | take-up roller |
| A | carbon distribution curve |
| B | silicon distribution curve |
| C | oxygen distribution curve |
| D | oxygen-carbon distribution curve |

## Claims

1. An electronic device comprising a gas barrier film comprising, in sequence:

   a resin substrate;
   a gas barrier layer; and
   an inorganic polymer layer,
   wherein,
   the gas barrier layer includes carbon atoms, silicon atoms, and oxygen atoms, the gas barrier layer having a composition of the carbon atoms, the silicon atoms, and the oxygen atoms continuously changing across the thickness of the gas barrier layer, the gas barrier layer satisfying Requirements (1) and (2),
   the inorganic polymer layer is formed by performing contraction on a layer comprising polysilazane so that a contraction rate is in a range of 10 to 30%,

   Requirement (1): in curves showing elemental distribution profiles based on elemental distribution measurement across a depth direction of the gas barrier layer observed through X-ray photoelectron spectroscopy, a carbon distribution curve, indicating correlation between a distance from one surface of the gas barrier layer in a thickness direction of the gas barrier layer and a percentage of the carbon atoms (referred to as "carbon atom percentage (at%)") to total content (100 at%) of silicon, oxygen, and carbon atoms, shows extrema; and a difference between a highest extremum (local maximum) of the carbon atom percentage and a lowest extremum (local minimum) of the carbon atom percentage is 5 at% or greater;
   Requirement (2): in an area of 90% or greater of an entire thickness of the gas barrier layer, the respective average percentage of the silicon, oxygen, and carbon atoms to the total content of the silicon, oxygen, and carbon atoms (100 at%) have a correlation defined by the following Inequality (A) or (B):

   Inequality (A): (average carbon atom percentage) < (average silicon atom percentage) < (average oxygen atom percentage);
   Inequality (B): (average oxygen atom percentage) < (average silicon atom percentage) < (average carbon atom percentage).

2. The electronic device according to claim 1, wherein the average percentage of the atom of each element have the correlation defined by Inequality (A).

3. The electronic device according to claim 1 or 2, wherein the inorganic polymer layer has a contraction rate in a range of 15 to 20%.

4. The electronic device according to any of claims 1 to 3, wherein the resin substrate of the gas barrier film has a thickness in a range of 15 to 150 μm.

5. A method of manufacturing a gas barrier film to be used in an electronic device, the gas barrier film comprising, in sequence, a resin substrate, at least one gas barrier layer deposited on at least one surface of the resin substrate, and at least one inorganic polymer layer deposited on the at least one gas barrier layer, the method comprising:

forming a gas barrier layer comprising carbon atoms, silicon atoms, and oxygen atoms, the gas barrier layer having a composition changing across a thickness direction, the gas barrier layer satisfying Requirements (1) and (2);
applying a polysilazane solution to form a coating layer onto the gas barrier layer;
drying the coating layer; and
contracting the dried coating layer into a contraction rate in a range of 10 to 30% to form an inorganic polymer layer:

Requirement (1): in curves showing elemental distribution profiles based on elemental distribution measurement across a depth direction of the gas barrier layer observed through X-ray photoelectron spectroscopy, a carbon distribution curve, indicating correlation between a distance from one surface of the gas barrier layer in a thickness direction of the gas barrier layer and a percentage of the carbon atoms (referred to as "carbon atom percentage (at%)") to total content (100 at%) of silicon, oxygen, and carbon atoms, shows extrema; and a difference between a highest extremum (local maximum) of the carbon atom percentage and a lowest extremum (local minimum) of the carbon atom percentage is 5 at% or greater;
Requirement (2): in an area of 90% or greater of an entire thickness of the gas barrier layer, the respective average percentage of the silicon, oxygen, and carbon atoms to the total content of the silicon, oxygen, and carbon atoms (100 at%) have a correlation defined by the following Inequality (A) or (B):

Inequality (A): (average carbon atom percentage) < (average silicon atom percentage) < (average oxygen atom percentage);
Inequality (B): (average oxygen atom percentage) < (average silicon atom percentage) < (average carbon atom percentage).

6. The method of manufacturing the gas barrier film according to claim 5, wherein the gas barrier layer is formed through plasma-enhanced chemical vapor deposition which involves depositing a material gas containing organosilicon compounds and an oxygen gas in a discharge space of an applied magnetic field between rollers.

7. The method of manufacturing the gas barrier film according to claim 5 or 6, wherein the contracting used in forming the inorganic polymer layer is by radiation of vacuum-ultraviolet light beams having a wavelength of 200 nm or less.

FIG.1

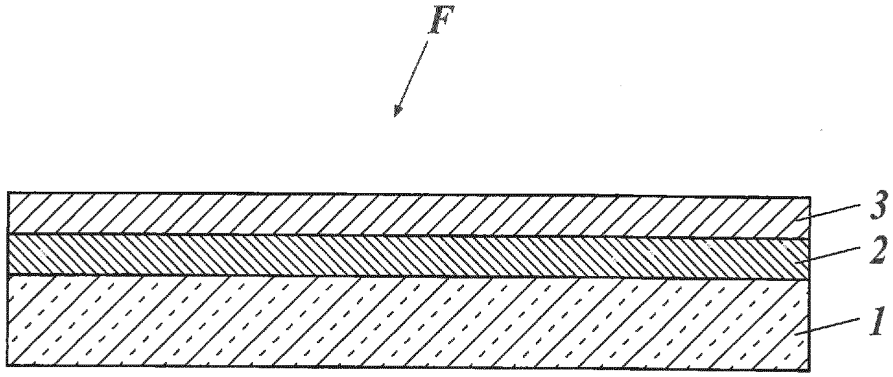


FIG.2

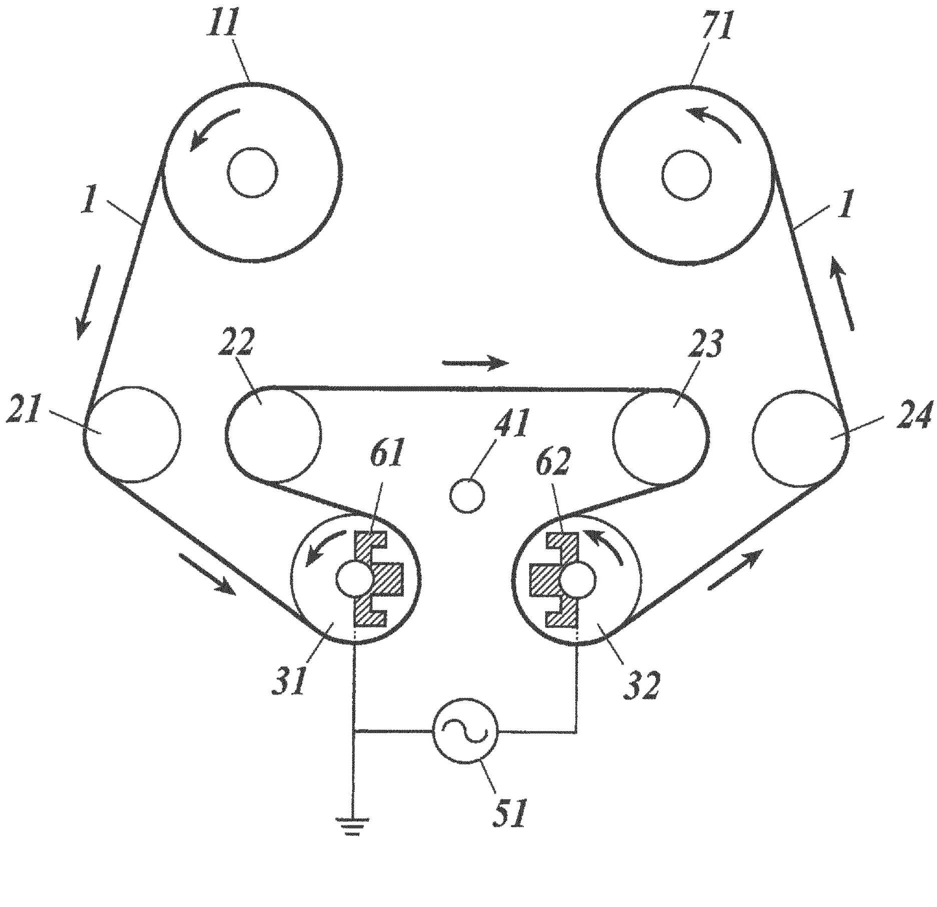

# FIG.3

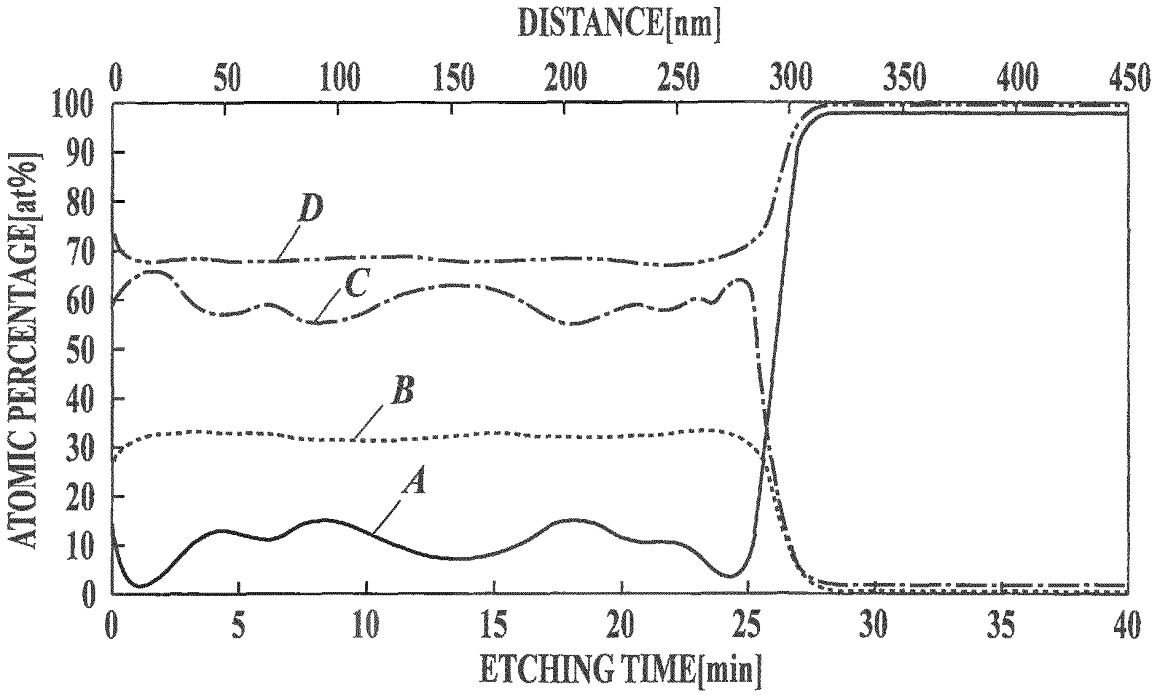
DISTANCE[nm]
0
50
100
150
200
250
300
350
400
450
ATOMIC PERCENTAGE[at%]
100
90
80
70
60
50
40
30
20
10
0
D
C
B
A
0
5
10
15
20
25
30
35
40
ETCHING TIME[min]

# FIG.4

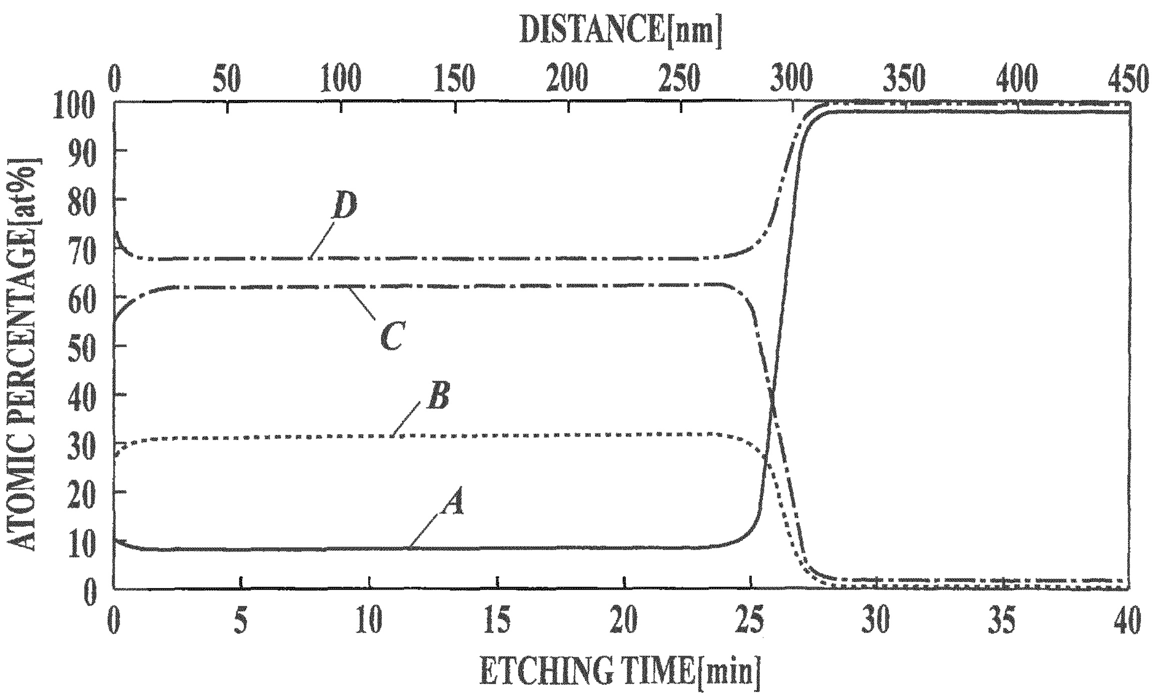
DISTANCE[nm]
0
50
100
150
200
250
300
350
400
450
ATOMIC PERCENTAGE[at%]
100
90
80
70
60
50
40
30
20
10
0
D
C
B
A
0
5
10
15
20
25
30
35
40
ETCHING TIME[min]

FIG.5

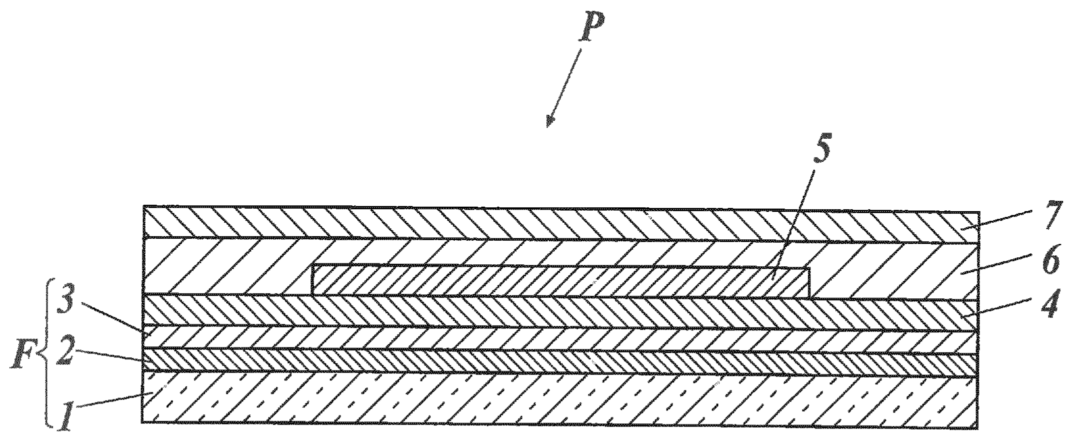

**INTERNATIONAL SEARCH REPORT**

International application No.
PCT/JP2013/079484

A. CLASSIFICATION OF SUBJECT MATTER
*H05B33/04*(2006.01)i, *B32B9/00*(2006.01)i, *C23C16/42*(2006.01)i, *C23C16/50*(2006.01)i, *H01L51/50*(2006.01)i, *H05B33/02*(2006.01)i, *H05B33/10*(2006.01)i

According to International Patent Classification (IPC) or to both national classification and IPC

B. FIELDS SEARCHED

Minimum documentation searched (classification system followed by classification symbols)
H05B33/04, B32B9/00, C23C16/42, C23C16/50, H01L51/50, H05B33/02, H05B33/10

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2013 |
| Kokai Jitsuyo Shinan Koho | 1971-2013 | Toroku Jitsuyo Shinan Koho | 1994-2013 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| Y | JP 2012-131194 A (Konica Minolta Holdings, Inc.), 12 July 2012 (12.07.2012), paragraphs [0002], [0094], [0095], [0099], [0121], [0170], [0181], [0186] (Family: none) | 1-7 |
| Y | JP 2012-84307 A (Sumitomo Chemical Co., Ltd.), 26 April 2012 (26.04.2012), paragraphs [0003] to [0005], [0008], [0053], [0054]; fig. 4, 11 & WO 2012/046741 A1 & TW 201232868 A | 1-7 |

☒ Further documents are listed in the continuation of Box C.　　☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 29 November, 2013 (29.11.13) | 10 December, 2013 (10.12.13) |

| Name and mailing address of the ISA/ | Authorized officer |
|---|---|
| Japanese Patent Office | |
| Facsimile No. | Telephone No. |

Form PCT/ISA/210 (second sheet) (July 2009)

**INTERNATIONAL SEARCH REPORT**

International application No.
PCT/JP2013/079484

C (Continuation). DOCUMENTS CONSIDERED TO BE RELEVANT

| Category* | Citation of document, with indication, where appropriate, of the relevant passages | Relevant to claim No. |
|---|---|---|
| Y | WO 2012/067230 A1 (Konica Minolta Holdings, Inc.), 24 May 2012 (24.05.2012), paragraphs [0186] to [0192] (Family: none) | 1-7 |
| Y | JP 2012-106421 A (Konica Minolta Holdings, Inc.), 07 June 2012 (07.06.2012), paragraphs [0035], [0065], [0066], [0070] (Family: none) | 1-7 |

Form PCT/ISA/210 (continuation of second sheet) (July 2009)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- WO 2012046767 A
- JP H945479 B
- JP H9260062 B
- JP H8288069 B
- JP H6325871 B
- JP H917574 B
- JP H1074586 B

### Non-patent literature cited in the description

- Yuki EL Soshi to Sono Kogyoka Saizensen. Denky-oku Zairyo. N.T.S. Co., Ltd, 30 November 1998, 123-166